# EUROPEAN PATENT APPLICATION

(11) **EP 1 814 146 A1**
(43) Date of publication of application: **01.08.2007**
(21) Application number: 05806839.6
(22) Date of filing: 18.11.2005
(51) Int. Cl.: H01L 21/027, G03F 7/20

(54) **MAINTENANCE METHOD, EXPOSURE METHOD, EXPOSURE APPARATUS, AND DEVICE PRODUCING METHOD**

(30) Priority: 19.11.2004 JP 2004336135; 17.06.2005 JP 2005177596
(71) Applicant: NIKON CORPORATION, Tokyo 100-8831 (JP)
(72) Inventor: NAGASAKA, Hiroyuki NIKON CORPORATION I.P. Dept., Tokyo 1008331 (JP); OKADA, Takaya NIKON CORPORATION I.P. Dept., Tokyo 1008331 (JP); UEDA, Motoi NIKON CORPORATION I.P. Dept., Tokyo 1008331 (JP); HOSHIKA, Ryuichi NIKON CORPORATION I.P. Dept., Tokyo 1008331 (JP)
(74) Representative: Steinmeister, Helmut
(86) International application number: PCT/JP2005/021287
(87) International publication number: WO 2006/054719

(57) **Abstract**

An exposure apparatus irradiates an exposure light beam EL in a state that a space KS, between predetermined optical elements LS1 and LS2 among a plurality of optical elements included in a projection optical system, is filled with a liquid LQ. When the exposure light beam EL is not irradiated during, for example, the maintenance or the like, the liquid LQ in the space KS is substituted by a functional fluid LK different from the liquid LQ. This makes it possible to reduce any influence exerted by the liquid LQ on the exposure apparatus.

## Description

### TECHNICAL FIELD

The present invention relates to a maintenance method for an exposure apparatus, an exposure method, an exposure apparatus, and a method for producing device.

### BACKGROUND ART

In photolithography, as a process for producing a microdevice such as a semiconductor device, a liquid crystal display device and the like, an exposure apparatus which projects a pattern formed on a mask onto a photosensitive substrate and exposes the pattern on the mask is employed. This exposure apparatus includes a mask stage which supports a mask and a substrate stage which supports a substrate, and projects an image of the pattern of the mask onto the substrate via a projection optical system while successively moving the mask stage and the substrate stage. In microdevice production, for higher integration of the device, there is a demand to miniaturize the pattern to be formed on the substrate. To meet this demand, higher resolution of the exposure apparatus is desired. As one of the means for realizing this higher resolution, a liquid immersion exposure apparatus is proposed which forms a liquid immersion area by filling a liquid in a space between the projection optical system and the substrate and which performs the exposure process through the liquid in the liquid immersion area, as disclosed, for example, International Publication No. 99/49504.

### DISCLOSURE OF THE INVENTION

### Problem to be Solved by the Invention

In a liquid immersion exposure apparatus and/or a liquid immersion optical system which is provided in the liquid immersion exposure apparatus, when a liquid filling a predetermined space through which an exposure light beam is transmitted is left for a long period of time, then there is a possibility that the liquid that is deteriorated due to the generation (bleeding) of bacteria and/or that a member (optical element, etc.) which is in contact with the liquid that is deteriorated. Further, there is also a possibility that when the liquid in the predetermined space merely is recovered (discharged), the liquid remains on the member (optical element) which has been in contact with the liquid, and any contaminant (pollutant) may adhere to the member.

The present invention has been made in view of these situations, and an object thereof is to provide a maintenance method for exposure apparatus, an exposure method, an exposure apparatus, and a method for producing device using the exposure method and the exposure apparatus which can maintain desired performance even when the liquid immersion method is used.

### Means for Solving the Problem:

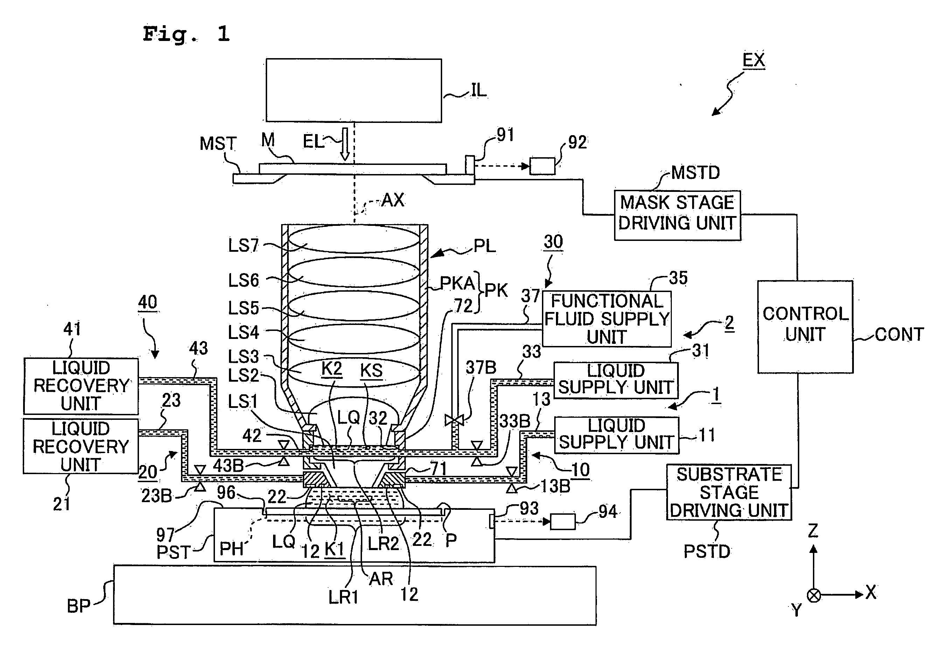

In order to achieve the object, the present invention adopts the following constructions corresponding to Fig. 1 to Fig. 8 as illustrated in the embodiments. However, parenthesized reference numerals affixed to respective elements merely exemplify the elements by way of example, with which it is not intended to limit the respective elements.

According to a first aspect of the invention, there is provided a maintenance method for an exposure apparatus (EX) which exposes a substrate (P) by irradiating an exposure light beam (EL) onto the substrate (P) via a projection optical system (PL) including a plurality of optical elements (LS1 to LS7); the method comprising: performing exposure for the substrate by irradiating the exposure light beam (EL) in a state that a predetermined space (K2, KS) between predetermined optical elements (LS1 and LS2) among the plurality of optical elements (LS1 to LS7) is filled with a first liquid (LQ); and substituting the first liquid in the predetermined space (K2, KS) by a second liquid (LK) different from the first liquid (LQ) when the exposure light beam (EL) is not irradiated.

According to the first aspect of the invention, when the exposure light beam is not irradiated, the first liquid in the predetermined space is substituted by the second liquid to thereby make it possible to prevent the deterioration of the first liquid and the deterioration and contamination of the optical elements.

According to a second aspect of the invention, there is provided a maintenance method for an exposure apparatus (EX) which exposes a substrate (P) by irradiating an exposure light beam (EL) onto the substrate (P), the method comprising: performing exposure for the substrate by irradiating the exposure light beam (EL) in a state that a predetermined space (K2, KS, etc.) as a part of an optical path space for the exposure light beam (EL) is filled with liquid (LQ); and supplying a gas (G) to the predetermined space (K2, KS), when the exposure light beam (EL) is not irradiated, while adjusting temperature of an object (LS1, LS2) which forms the predetermined space (K2, KS) to remove the liquid (LQ) from the predetermined space (K2, KS).

According to the second aspect of the invention, when the liquid is removed, the gas is supplied while adjusting temperature of the object, thereby making it possible to suppress the temperature change in the object due to the supply of the gas.

According to a third aspect of the invention, there is provides an exposure method for exposing a substrate by irradiating an exposure light beam (EL) onto the substrate (P) via a projection optical system (PL) which includes a plurality of optical elements (LS1 to LS7), the method comprising: irradiating the exposure light beam (EL) onto the substrate in a state that a predetermined space (K2, KS) between predetermined optical elements (LS1 and LS2) among the plurality of optical elements is filled with a first liquid (LQ); and substituting the first liquid in the predetermined space (K2, KS) by a second liquid (LK) different from the first liquid when the exposure light beam (EL) is not irradiated.

According to the third aspect of the invention, when the exposure light beam is not irradiated, the first liquid in the predetermined space is substituted by the second liquid to thereby prevent the deterioration of the first liquid and the deterioration and contamination of the optical elements.

According to a fourth aspect of the invention, there is provided an exposure apparatus (EX) which exposes a substrate (P) by irradiating an exposure light beam (EL) onto the substrate (P), the apparatus comprising: a projection optical system (PL) which includes a plurality of optical elements (LS1 to LS7); and a liquid immersion mechanism (35, etc.) which fills a predetermined space (K2, KS) between predetermined optical elements (LS1 and LS2) among the plurality of optical elements (LS1 to LS7) with a first liquid (LQ), and which substitutes the first liquid (LQ) in the predetermined space (K2, KS) by a second liquid (LK) different from the first liquid (LQ) when the exposure light beam (EL) is not irradiated.

According to the fourth aspect of the invention, when the exposure light beam is not irradiated, first liquid in the predetermined space is substituted by the second liquid, to thereby prevent the deterioration of the first liquid and the deterioration and contamination of optical elements used in the exposure apparatus.

According to a fifth aspect of the invention, there is provided an exposure apparatus (EX) which exposes a substrate (P) by irradiating an exposure light beam (EL) onto the substrate (P), the apparatus comprising: a liquid immersion mechanism (35, etc.) which fills a predetermined space (K2, KS) as a part of an optical path space for the exposure light beam (EL) when irradiating the exposure light beam (EL) onto the substrate(P); a gas supply system (50) which supplies a gas (G) to the predetermined space (K2, KS) when the exposure light beam (EL) is not irradiated to remove the liquid (LQ) from the predetermined space (K2, KS); and a temperature-adjusting device (temperature controller) (61, 62) which adjusts temperature of an object (LS1, LS2) forming the predetermined space (K2, KS) when supplying the gas (G).

According to the fifth aspect of the invention, when removing the liquid, by supplying the gas while adjusting the temperature of the object, the temperature change in the object due to the supply of the gas can be suppressed.

According to a sixth aspect of the invention, there is provided an exposure apparatus (EX) which exposes a substrate (P) by irradiating an exposure light beam (EL) onto the substrate (P), comprising: a projection optical system (PL) which includes a plurality of optical elements (LS1 to LS7); a liquid immersion mechanism (35, etc.) which fills a predetermined space (K2, KS) between predetermined optical elements (LS1 and LS2) among the plurality of optical elements (LS1 to LS7) with a liquid (LQ); and a gas supply system (50) which supplies a gas (G) into the predetermined space (K2, KS) when the exposure light beam (EL) is not irradiated.

In the exposure apparatus of the sixth aspect, the inside of the predetermined space is dried by supplying the gas into the predetermined space by the gas supply system, so that any harmful influence which would otherwise affect the liquid immersion exposure can be reduced.

According to a seventh aspect of the invention, there is provided a method for producing a device, comprising using the exposure apparatus (EX) of any of the aspects described above. According to the seventh aspect of the invention, a device with desired performance can be produced by using the exposure apparatus in which the influence from the liquid is reduced.

According to an eighth aspect of the invention, there is provided a method for producing a device, comprising an exposure step by using the exposure method of the aspect described above; a step for developing the substrate after the exposure step; and a step for processing the developed substrate. According to the eighth aspects of the invention, a device with desired performance can be produced by using the exposure method in which the influence from the liquid is reduced.

### Effect of the Invention:

According to the invention, even when the liquid immersion method is used, it is possible to maintain the exposure accuracy and measurement accuracy.

### BRIEF DESCRIPTION OF THE DRAWINGS

Fig. 1 is a schematic arrangement view showing a first embodiment of an exposure apparatus according to the invention;
Fig. 2 is an enlarged view of the main portion of Fig. 1;
Figs. 3(A) to 3(C) are drawings for describing a maintenance method according to a first embodiment;
Figs. 4(A) to 4(C) are drawings for describing maintenance methods according to second and third embodiments;
Figs. 5(A) to 5(C) are drawings for describing a maintenance method according to a fourth embodiment;
Figs. 6(A) and 6(B) are drawings for describing a maintenance method according to a fifth embodiment;
Fig. 7 is a drawing for describing a maintenance method according to a sixth embodiment; and
Fig. 8 is a flowchart showing an example of steps for producing a microdevice.

### Legends of Reference Numerals

1: first liquid immersion mechanism, 2: second liquid immersion mechanism, 10: first liquid supply mechanism, 12: first supply port, 20: second liquid recovery mechanism, 22: first recovery port, 30: second liquid supply mechanism, 31: liquid supply unit, 32: second supply port, 35: functional fluid supply unit, 33B, 37B: valve, 40: second liquid recovery mechanism, 42: second recovery port, 50: gas supply system, 61, 62: temperature-adjusting unit, 71: first nozzle member, 72: second nozzle member, 81, 82: temperature detector, EL: exposure light beam, EX: exposure apparatus, G: gas, K1: first space, K2: second space, KS: substitution space, LK: functional fluid, LQ: liquid, LS1 to LS7: optical element, LS1: first optical element, LS2: second optical element, P: substrate, PL: projection optical system

### BEST MODE FOR CARRYING OUT THE INVENTION

In the following, embodiments of the invention will be described with reference to the drawings. However, the invention is not limited to the embodiments.

### First embodiment

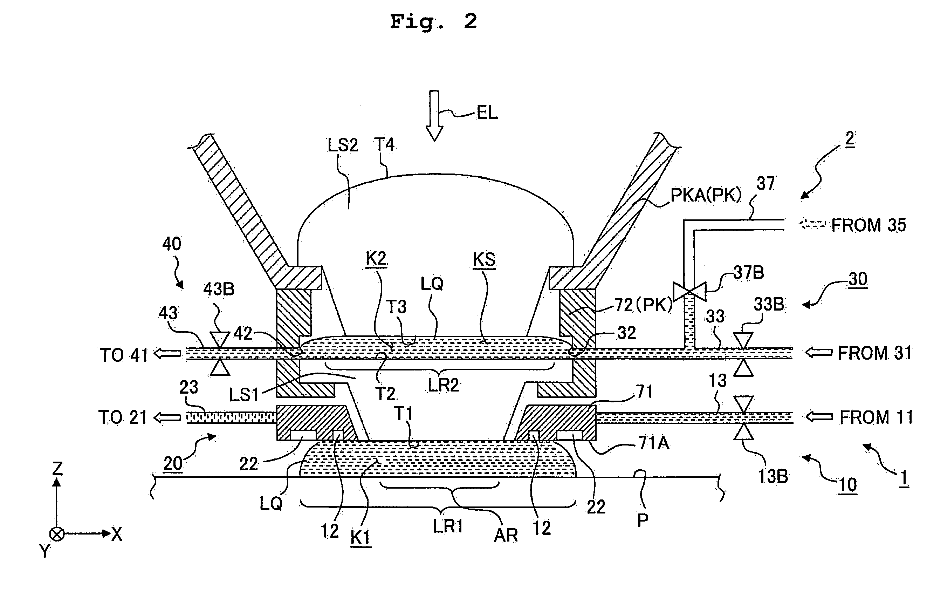

The first embodiment will be described with reference to the drawings. Fig. 1 is a schematic arrangement view showing an exposure apparatus according to the first embodiment, and Fig. 2 is an enlarge view showing the main portion of Fig. 1. In Figs. 1 and 2, the exposure apparatus EX includes a mask stage MST which is movable while holding a mask M; a substrate stage PST which has a substrate holder PH for holding a substrate P and is capable of moving the substrate holder PH with the substrate P held thereon; an illumination optical system IL which illuminates the mask M held on the mask stage MST by an exposure light beam EL; a projection optical system PL which projects an image of a pattern of the mask M illuminated by the exposure light beam EL onto the substrate P held on the substrate stage PST; and a control unit CONT which generally controls operations of the entire exposure apparatus EX. The projection optical system PL includes a plurality of optical elements LS1 to LS7, and these optical elements LS1 to LS7 are supported by a barrel PK.

The exposure apparatus EX of this embodiment is a liquid immersion exposure apparatus to which the liquid immersion method is applied to improve the resolution by substantially shortening the exposure wavelength and to substantially widen the depth of focus, and includes a first liquid immersion mechanism 1 which forms a first liquid immersion area LR1 by filling a liquid LQ in an optical path space between the substrate P and the first optical element LS1 closest to the image plane of the projection optical system PL among the plurality of optical elements LS1 to LS7 included in the projection optical system PL. The exposure apparatus EX of this embodiment adopts a local liquid immersion method for locally forming the first liquid immersion area LR1 of the liquid LQ, which is greater than a projection area AR and smaller than the substrate P, on a part or portion of a surface of the substrate P, the substrate part of portion including the projection area AR (area onto which the exposure light beam EL is irradiated) of the projection optical system PL.

Further, as described later on, the projection optical system PL is constructed so as to fill, with a liquid LQ, an optical path space between the first optical element LS1 closest to the image plane of the projection optical system PL and a second optical element LS2 next closest to the image plane of the projection optical system PL with respect to the first optical element LS1. The exposure apparatus EX also includes a second liquid immersion mechanism 2 which forms a second liquid immersion area LR2 on an upper surface T2 of the first optical element LS1 by filling the optical path space between the first optical element LS1 and the second optical element LS2 with the liquid LQ.

The first liquid immersion mechanism 1 includes a first nozzle member 71 having a first supply port 12 for supplying a liquid LQ and a first recovery port 22 for recovering the liquid LQ; a first liquid supply mechanism 10 which supplies the liquid LQ to the side of the image plane of the projection optical system PL through the first supply port 12 provided in the nozzle member 71; and a first liquid recovery mechanism 20 which recovers the liquid LQ on the side of the image plane of the projection optical system PL through the first recovery port 22 provided in the first nozzle member 71. The first nozzle member 71 is provided in the vicinity of the side of the image plane of the projection optical system PL, and is formed to have an annular shape so as to surround the first optical element LS1, at a position above or over the substrate P (substrate stage PST). Here, the first optical element LS1 in this embodiment is exposed from the barrel PK. Operations of the first liquid immersion mechanism 1 are controlled by the control unit CONT.

The second liquid immersion mechanism 2 includes a second nozzle member 72 having a second supply port 32 for supplying the liquid LQ and a second recovery port 42 for recovering the liquid LQ; a second liquid supply mechanism 30 which supplies the liquid LQ into the optical path space between the first optical element LS1 and the second optical element LS2 through the second supply port 32 provided in the second nozzle member 72; and a second liquid recovery mechanism 40 which recovers the liquid LQ, supplied by the second liquid supply mechanism 30, through the second recovery port 42 provided in the second nozzle member 72. The second nozzle member 72 is provided at a position above or over the first nozzle member 71, and is formed to have an annular shape so as to surround the optical path space between the first optical element LS1 and the second optical element LS2. Operations of the second liquid immersion mechanism 2 are controlled by the control unit CONT.

Here, in the description given below, the optical path space between the first optical element LS1 and the substrate P (substrate stage PST) will be referred to as "first space K1", the optical path space between the first optical element LS1 and the second optical element LS2 will be referred to as "second space K2", and a space surrounded by the first optical element LS1, the second optical element LS2, and the second nozzle member 72 will be referred to as "substitution space KS", as appropriate.

Thus, the second liquid immersion mechanism 2 is capable of supplying the liquid LQ into the substitution space KS by using the second liquid supply mechanism 30, and is capable of recovering the liquid LQ from the substitution space KS by using the second liquid recovery mechanism 40. In addition, as will be described later on, the second liquid supply mechanism 30 of the second liquid immersion mechanism 2 is capable of supplying another liquid (functional fluid) LK, which is different from the liquid LQ, to the substitution space KS.

The second nozzle member 72 also has a function as a holder (lens cell) for holding the first optical element LS1, and forms a part of the barrel PK. That is, in this embodiment, the barrel PK includes a barrel body PKA which holds the optical elements LS2 to LS7 and a holding member (second nozzle member) 72 which is connected to the lower end of the barrel body PKA and holds the first optical element LS1. It is not necessarily indispensable that the second nozzle member 72 forms the part of the barrel PK, and the second nozzle member 72 may be a member completely separate from the barrel PK.

This embodiment will now be explained as exemplified by a case in which a scanning type exposure apparatus (so-called scanning stepper) is used as the exposure apparatus EX in which the substrate P is exposed with the pattern formed on the mask M while synchronously moving the mask M and the substrate P in mutually different directions (opposite directions) in the scanning directions. In the following explanation, an X axis direction is a synchronous movement direction (scanning direction) of the mask M and the substrate P in a horizontal plane, an Y axis direction (non-scanning direction) is a direction orthogonal to the X axis direction in the horizontal plane, and a Z axis direction is a direction which is perpendicular to the X axis direction and the Y axis direction and is coincident with an optical axis AX of the projection optical system PL. The directions of rotation (inclination) about the X axis, the Y axis, and the Z axis are defined as θX, θY, and θZ directions, respectively. It should be note that the term "substrate" referred herein includes a substrate obtained by coating a photosensitive material (resist) on a semiconductor wafer, and that the term "mask" includes a reticle having a device pattern which is to be subjected to the reduction projection onto the substrate.

The illumination optical system IL includes an exposure light source which emits an exposure light beam EL, an optical integrator which uniformizes illuminance of the exposure light beam EL emitted from the exposure light source, a condenser lens which collects the exposure light beam EL from the optical integrator, a relay lens system, a field diaphragm which defines an illumination area on the mask M to be illuminated by the exposure light beam EL, and the like. A predetermined illumination area on the mask M is illuminated by the exposure light beam EL with a uniform illuminance distribution by the illumination optical system IL. Light beams usable as the exposure light beam EL emitted from the exposure light source include, for example, emission lines (g-ray, h-ray, i-ray) radiated, for example, from a mercury lamp; far ultraviolet light beams (DUV light beams) such as the KrF excimer laser beam (wavelength: 248 nm); vacuum ultraviolet light beams (VUV light beams) such as the ArF excimer laser beam (wavelength: 193 nm) and the F₂ laser beam (wavelength: 157 nm); and the like. In this embodiment, the ArF excimer laser beam is used.

In this embodiment, pure or purified water is used as the liquid LQ for forming the first liquid immersion area LR1 and as the liquid LQ for forming the second liquid immersion area LR. That is, in this embodiment, the liquid LQ for forming the first liquid immersion area LR1 and the liquid LQ for forming the second liquid immersion area LR2 are of the same kind. Not only the ArF excimer laser beam but also the emission line (g-ray, h-ray, i-ray) radiated, for example, from a mercury lamp and the far ultraviolet light beam (DUV light beam) such as the KrF excimer laser beam (wavelength: 248 nm) are also transmissive through pure water. To obtain desired optical characteristic, the liquid LQ for forming the first liquid immersion area LR1 and the liquid LQ for forming the second liquid immersion area LR2 may be different from each other provided that the exposure light beam EL is transmissive therethrough. Also, even when the liquid for forming the first liquid immersion area LR1 and the liquid for forming the second liquid immersion area LR2 are of the same kind, the liquids may have mutually different properties (temperature, specific resistance, TOC, etc.).

The mask stage MST is movable while holding the mask M. The mask stage MST holds the mask M by vacuum adsorption (or electrostatic adsorption). The mask stage MST is two-dimensionally movable in the plane perpendicular to the optical axis AX of the projection optical system PL, namely, in an XY plane and is slightly rotatable in the θZ direction while holding the mask M, by the driving of the mask stage-driving unit MSTD which includes a linear motor or the like and is controlled by the control unit CONT. On the mask stage MST, a movement mirror 91 which moves together with the mask stage MST is provided in a fixed manner. Further, a laser interferometer 92 is provided at a position opposite to or facing the movement mirror 91. Two-dimensional position and angle of rotation in the θZ direction (including angles of rotation in θX and θY directions in some cases) of the mask M on the mask stage MST are measured by the laser interferometer 92 in real time. The result of measurement by the laser interferometer 92 is outputted to the control unit CONT. The control unit CONT drives the mask stage-driving unit MSTD based on the result of the measurement performed by the laser interferometer 92 and controls the position of the mask M held on the mask stage MST.

The projection optical system PL projects a pattern of the mask M onto the substrate P at a predetermined projection magnification β. The projection optical system PL in this embodiment is a reduction system having the projection magnification β which is, for example, 1/4, 1/5 or 1/8, and is a dioptric system including no catoptric element. It should be noted that the projection optical system PL may be a catoptric system or a catadioptric system. Further, the projection optical system PL may be a x1 magnification system or a magnifying system. Furthermore, in this embodiment, the first optical element LS1 is a plane-parallel which has no refractive power and through which the exposure light beam EL is transmissive, and the lower surface T1 and the upper surface T2 of the first optical element LS2 are approximately parallel to each other. On the other hand, the second optical element LS2 has a refractive power (lens function). The first optical element LS1 may be shaped or its material may be selected so that the first optical element LS1 has a refractive power (lens function).

The substrate stage PST has a substrate holder PH which holds the substrate P, and is movable on a base member BP, on the side of the image plane of the projection optical system PL. The substrate holder PH holds the substrate P by, for example, vacuum adsorption. On the substrate stage PST, a recess 96 is provided, and the substrate holder PH which holds the substrate P is disposed in the recess 96. An upper surface 97 of the substrate stage PST, except for the recess 96, is formed as a flat surface (flat portion) to be approximately at a same height as (flush with) the upper surface of the substrate P held on the substrate holder PH.

The substrate stage PST is two-dimensionally movable in the XY plane and finely rotatable in the θZ direction on the base member BP, in a state that the substrate P is held on the substrate stage PST via the substrate holder PH, by the drive of the substrate stage-driving unit PSTD which includes a linear motor, etc., and which is controlled by the control unit CONT. Further, the substrate stage PST is movable also in the Z axis direction, θX direction, and θY direction. Therefore, the upper surface of the substrate P supported on the substrate stage PST is movable in six degrees of freedom of directions of X axis, Y axis, Z axis, θX, θY, and θZ. On a side surface of the substrate stage PST, a movement mirror 93 which moves together with the substrate stage PST is provided in a fixed manner. Further, a laser interferometer 94 is provided at a position opposite to or facing the movement mirror 93. The two-dimensional position and the angle of rotation of the substrate P on the substrate stage PST are measured in real time by the laser interferometer 94. The exposure apparatus EX includes a focus/leveling-detecting system (not shown) based on the oblique incidence system which detects the surface position information about the surface of the substrate P supported by the substrate stage PST, as disclosed, for example, in Japanese Patent Application Laid-open No. 8-37149. The focus/leveling-detecting system detects a surface position information about the surface of the substrate P (position information in the Z axis direction, and information about the inclination in the θX and θY directions of the substrate P). A system, which uses an electrostatic capacity type sensor, may be adopted as the focus/leveling-detecting system. The result of measurement performed by the laser interferometer 94 is outputted to the control unit CONT. The result of detection performed by the focus/leveling-detecting system is also outputted to the control unit CONT. The control unit CONT drives the substrate stage-driving unit PSTD based on the detection result of the focus/leveling-detecting system to adjust and match the upper surface of the substrate P with respect to the image plane of the projection optical system PL by controlling the focus position (Z position) and the angle of inclination (θX, θY) of the substrate P. Further, the control unit CONT controls the position of the substrate P in the X axis direction, the Y axis direction, and the θZ direction based on the measurement result of the laser interferometer 94.

Next, the first liquid immersion mechanism 1 and the second liquid immersion mechanism 2 will be described. The first liquid supply mechanism 10 of the first liquid immersion mechanism 1 supplies the liquid LQ to the optical path space (first space) K1 between the substrate P and the first optical element LS1 of the projection optical system PL. The first liquid supply mechanism 10 includes a liquid supply unit 11 capable of supplying the liquid LQ and a first supply tube 13 of which one end is connected to the liquid supply unit 11. The other end of the first supply tube 13 is connected to the first nozzle member 71. A first valve 13B for opening and closing the flow passage of the first supply tube 13 is provided to the first supply tube 13 at an intermediate position thereof. An internal flow passage (supply flow passage), which connects the other end of the first supply tube 13 and the first supply port 12 is formed in the first nozzle member 71. The liquid supply unit 11 of the first liquid immersion mechanism 1 includes a tank which accommodates the liquid LQ, a pressurizing pump, a filter unit which removes any foreign matter in the liquid LQ, and the like. The supplying operation of the liquid supply unit 11 and the opening/closing operation of the first valve 13B are controlled by the control unit CONT.

The first liquid recovery mechanism 20 of the first liquid immersion mechanism 1 recovers the liquid LQ supplied by the first liquid supply mechanism 10. The first liquid recovery mechanism 20 includes a liquid recovery unit 21 capable of recovering the liquid LQ and a first recovery tube 23 of which one end is connected to the liquid recovery unit 21. The other end of the first recovery tube 23 is connected to the first nozzle member 71. A second valve 23B for opening and closing the flow passage of the first recovery tube 23 is provided in the first recovery tube 23 at an intermediate position thereof. An internal flow passage (recovery flow passage) which connects the other end of the first recovery tube 23 and the first recovery port 22 is formed in the first nozzle member 71. The liquid recovery unit 21 of the first liquid immersion mechanism 1 includes a vacuum system (sucking unit) such as a vacuum pump, a gas/liquid separator which separates the recovered liquid LQ and a gas from each other, a tank which accommodates the recovered liquid LQ, and the like. The recovering operation of the liquid recovery unit 21 and the opening/closing operation of the second valve 23B are controlled by the control unit CONT.

The first supply port 12 which supplies the liquid LQ and the first recovery port 22 which recovers the liquid LQ are formed in the lower surface 71A of the first nozzle member 71. The lower surface 71A of the first nozzle member 71 is provided at a position at which the lower surface 71A is opposite to or facing the upper surface of the substrate P and the upper surface 97 of the substrate stage PST. The first supply port 12 is provided as a plurality of first supply ports 12 in the lower surface 71A of the first nozzle member 71 so as to surround the first optical element LS1 of the projection optical system PL (optical axis AX of the projection optical system PL). The first recovery port 22 is provided as a plurality of first recovery ports 22 in the lower surface 71A of the first nozzle member 71 further away and outwardly, from the first optical element LS1, than the first supply ports 12, and are provided so as to surround the first optical element LS1 and the first supply ports 12.

The second liquid supply mechanism 30 of the second liquid immersion mechanism 2 supplies the liquid LQ to the substitution space KS which includes the optical path space (second space) K2 between the first optical element LS1 and the second optical element LS2 of the projection optical system PL. The second liquid supply mechanism 30 includes a liquid supply unit 31 capable of supplying the liquid LQ and a second supply tube 33 of which one end is connected to the liquid supply unit 31. The other end of the second supply tube 33 is connected to the second nozzle member 72. A third valve 33B for opening and closing a flow passage of the second supply tube 33 is provided to the second supply tube 33 at an intermediate position thereof. An internal flow passage (supply flow passage) connecting the other end of the second supply tube 33 and the second supply port 32 is formed in the second nozzle member 72. The liquid supply unit 31 of the second liquid immersion mechanism 2 includes a tank which accommodates the liquid LQ, a pressurizing pump, a filter unit which removes any foreign matter in the liquid LQ, and the like. The supplying operation of the liquid supply unit 31 and the opening/closing operation of the third valve 33B are controlled by the control unit CONT.

The second liquid recovery mechanism 40 of the second liquid immersion mechanism 2 recovers the liquid LQ supplied by the second liquid supply mechanism 30. The second liquid recovery mechanism 40 includes a liquid recovery unit 41 capable of recovering the liquid LQ and a second recovery tube 43 of which one end is connected to the liquid recovery unit 41. The other end of the second recovery tube 43 is connected to the second nozzle member 72. A fourth valve 43B which opens and closes the flow passage of the second recovery tube 43 is provided to the second recovery tube 43 at an intermediate position thereof. An internal flow passage (recovery flow passage) which connects the other end of the second recovery tube 43 and the second recovery port 42 is formed in the second nozzle member 72. The liquid recovery unit 41 of the second liquid immersion mechanism 2 includes a vacuum system (sucking unit) such as a vacuum pump, a gas/liquid separator which separates the recovered liquid LQ and the gas from each other, a tank which accommodates the recovered liquid LQ, and the like. The recovering operation of the liquid recovery unit 41 and the opening/closing operations of the fourth valve 43B are controlled by the control unit CONT.

The second supply port 32 which supplies the liquid LQ and the second recovery port 42 which recovers the liquid LQ are formed in the inner surface of the second nozzle member 72, and each of the second supply port 32 and the second recovery port 42 is connected to the substitution space KS including the second space K2. In this embodiment, the second supply port 32 is provided on one side (+X side) of the inner surface of the second nozzle member 72 with respect to the optical axis AX, and the second recovery port 42 is provided on the other side (-X side).

It is not necessarily indispensable that the tank, pressurizing pump, and filter unit of each of the liquid supply units 11 and 31 are all included in the body of the exposure apparatus EX, and equipment or facilities of the factory in which the exposure apparatus EX is installed may be used instead. Similarly, it is not necessarily indispensable that the vacuum system, gas/liquid separator, and tank, etc., of each of the liquid recovery units 21 and 41 are all included in the exposure apparatus EX, and facilities of a factory in which the exposure apparatus EX is installed may be used instead. Here, although the first and second liquid immersion mechanisms 1 and 2 have the liquid supply units 11 and 31 independently from each other, the first and second liquid immersion mechanisms 1 and 2 may share one common liquid supply unit. Similarly, the first and second liquid immersion mechanisms 1 and 2 may share one common liquid recovery unit.

The second liquid supply mechanism 30 of the second liquid immersion mechanism 2 includes a functional fluid supply unit 35 capable of supplying a functional fluid LK having a predetermined function. To the functional fluid supply unit 35, a third supply tube 37 is connected at one end thereof, and the third supply tube 37 is connected, at the other end thereof, to the second supply tube 33 at an intermediate position of the second supply tube 33. In the intermediate position of the third supply tube 37, a fifth valve 37B which opens and closes the flow passage of the third supply tube 37 is provided. The functional fluid supply unit 35 includes a tank which accommodates the functional fluid LK, a pressurizing pump, a filter unit which removes any foreign matters in the functional fluid LK, and the like. However, it is not necessarily indispensable that the tank, pressurizing pump, and filter unit, and the like for the functional fluid LK are all included in the body of the exposure apparatus EX, and it is allowable that equipment of the factory in which the exposure apparatus EX is installed is used instead. The supplying operation of the functional fluid supply unit 35 is controlled by the control unit CONT. The functional fluid LK has a function to suppress the generation (emergence) of living microbes, and the functional fluid LK is a solution of oxygenated water (hydrogen peroxide solution) in this embodiment. The supplying operation of the functional fluid supply unit 35 and the opening/closing operation of the fifth valve 37B are controlled by the control unit CONT.

The control unit CONT is capable of supplying the functional fluid LK fed out from the functional fluid supply unit 35 to the substitution space KS including the second space K2, via the third supply tube 37, the second supply tube 33, and the second supply port 32 of the second nozzle member 72, by driving the third valve 33B and the fifth valve 37B to close the flow passage of the second supply tube 33 connected to the liquid supply unit 31 and to open the flow passage of the third supply tube 37 connected to the functional fluid supply unit 35. Namely, the control unit CONT is capable of switching between the supply of the liquid LQ to the substitution space KS by the liquid supply unit 31 and the supply of the functional fluid LK to the substitution space KS by the functional fluid supply unit 35 via the second supply port 32, by controlling the operations of the third and fifth valves 33B and 37B.

Next, an explanation will be given about operations for exposing the substrate P by using the exposure apparatus EX constructed as described above.

As shown in Fig. 2, at least during a period of time in which the image of the pattern of the mask M is being projected onto the substrate P, the control unit CONT uses the first liquid immersion mechanism 1 to thereby form a first liquid immersion area LR1 by filling, with the liquid LQ, the optical path space (first space) K1 between the first optical element LS1 and the substrate P disposed on the side of the image plane of the first optical element LS1, and the control unit CONT uses the second liquid immersion mechanism 2 to thereby form, with the liquid LQ, a second liquid immersion area LR2 by filling the optical path space (second space) K2 between the first optical element LS1 and the second optical element LS2.

Upon filling the first space K1 with the liquid LQ, the control unit CONT drives each of the liquid supply unit 11 and the liquid recovery unit 21 of the first liquid immersion mechanism 1. In addition, the control unit CONT drives the first valve 13B to open the flow passage of the first supply tube 13 connected to the liquid supply unit 11 and drives the second valve 23B to open the flow passage of the first recovery tube 23 connected to the liquid recovery unit 21. When the liquid LQ is fed out from the liquid supply unit 11 under the control of the control unit CONT, the liquid LQ fed out from the liquid supply unit 11 flows through the first supply tube 13, and then is supplied to the side of the image plane of the projection optical system PL from the first supply ports 12 through the supply flow passage of the first nozzle member 71. When the liquid recovery unit 21 is driven under the control of the control unit CONT, the liquid LQ on the side of the image plane of the projection optical system PL flows into the recovery flow passage of the first nozzle member 71 through the first recovery ports 22 and flows through the first recovery tube 23, and then is recovered by the liquid recovery unit 21.

The control unit CONT supplies a predetermined amount of the liquid LQ onto the substrate P by using the first liquid supply mechanism 10, and recovers a predetermined amount of the liquid LQ on the surface of the substrate P by using the first liquid recovery mechanism 20, to thereby locally form the first liquid immersion area LR1 of the liquid LQ on the substrate P. The control unit CONT continues the operations for supplying and recovering the liquid LQ by using the first liquid immersion mechanism 1 at least during irradiation of the substrate P with the exposure light beam EL, so as to fill, with the liquid LQ, the optical path space (first space) K1 between the first optical element LS1 and the substrate P.

Upon filling the second space K2 with the liquid LQ, the control unit CONT drives the liquid supply unit 31 and the liquid recovery unit 41 of the second liquid immersion mechanism 2. At this time, the control unit CONT opens the flow passage of the second supply tube 33 connected to the liquid supply unit 31 and closes the flow passage of the third supply tube 37 connected to the functional fluid supply unit 35 by driving the third and fifth valves 33B and 37B respectively. The control unit CONT drives the fourth valve 43B to open the flow passage of the second recovery tube 43 connected to the liquid recovery unit 41. When the liquid LQ is fed out from the liquid supply unit 31 under the control of the control unit CONT, the liquid LQ fed out from the liquid supply unit 31 flows through the second supply tube 33, and is then supplied to the substitution space KS including the second space K2 from the second supply port 32 through the supply flow passage of the second nozzle member 72. When the liquid recovery unit 41 is driven under the control of the control unit CONT, the liquid LQ in the substitution space KS flows into the recovery flow passage of the second nozzle member 72 through the second recovery port 42 and flows through the second recovery tube 43, and is then recovered by the liquid recovery unit 41.

The control unit CONT fills at least the second space K2 of the substitution space KS by supplying a predetermined amount of the liquid LQ into the substitution space KS including the second space K2 by using the second liquid supply mechanism 30 and by recovering a predetermined amount of the liquid LQ from the substitution space KS by using the second liquid recovery mechanism 40. The control unit CONT performs operations for supplying and recovering the liquid LQ by the second liquid immersion mechanism 2 so as to fill the optical path space (second space) K2 between the first optical element LS1 and the second optical element LS2 with the liquid LQ.

The second liquid immersion mechanism 2 may fill only a part of the substitution space KS including the optical path space (second space) K2 between the first optical element LS1 and the second optical element LS2 with the liquid LQ, or may fill the entire substitution space KS with the liquid LQ. Namely, it is sufficient that the optical path space (second space) K2 for the exposure light beam EL between the first optical element LS1 and the second optical element LS2 is filled with the liquid LQ.

It is allowable that the liquid amount supplied by the second liquid immersion mechanism 2 is smaller than the liquid amount supplied by the first liquid immersion mechanism 1; and it is also allowable to stop the liquid supplying operation and the liquid recovering operation of the second liquid immersion mechanism 2 when the exposure light beam EL is passing through the projection optical system PL, and to perform the liquid supplying operation and the liquid recovering operation by the second liquid immersion mechanism 2 only when the exposure light beam EL is not passing through the projection optical system PL during the exchange of the substrate P and/or the like.

The control unit CONT projects and exposes a pattern of the mask M onto the substrate P by irradiating, onto the substrate P, the exposure light beam EL passing via the mask M and via the projection optical system PL and the liquids LQ in the first and second spaces K1 and K2, in a state that the first space K1 and the second space K2 which are optical path spaces for the exposure light beam EL are filled with the liquid LQ. The exposure light beam EL exiting from the illumination optical system IL comes into the projection optical system PL from the side of the object plane, and passes through the optical elements LS7 to LS3, and then passes through a predetermined area of the upper surface T4 of the second optical element LS2, then passes through a predetermined area of the lower surface T3, and then comes into the second liquid immersion area LR2. The exposure light beam EL which passed through the second liquid immersion area LR2 passes through a predetermined area of the upper surface T2 of the first optical element LS1, and then is allowed to exit from a predetermined area of the lower surface T1, then comes into the first liquid immersion area LR1, and then reaches the surface of the substrate P.

In this embodiment, the space which is between the first optical element LS1 and the substrate P and which includes the first space K1 and the substitution space KS which includes the second space K2 are independent from each other so as to prevent the liquid LQ and the functional fluid LK from inflowing and outflowing from one to the other of the first space K1 and the second space K2 (substitution space KS). The control unit CONT is capable of performing the operations for supplying and recovering the liquid LQ into and from the first space K1 by using the first liquid immersion mechanism 1 and the operations for supplying and recovering the liquid LQ into and from the second space K2 (substitution space KS) by using the second liquid immersion mechanism 2, independently from each other.

Then, by filling the first space K1 and the second space K2 with the liquid LQ, the difference in refractive index is small at the interfaces between the second optical element LS2 and the first optical element LS1 and the first space K1 and the second space K2. Accordingly, it is possible to reduce the reflection loss at the lower surface T3 of the second optical element LS2 and at the upper surface T2 of the first optical element LS1, thereby making it possible to expose the substrate P satisfactorily while securing a large numerical aperture on the side of the image.

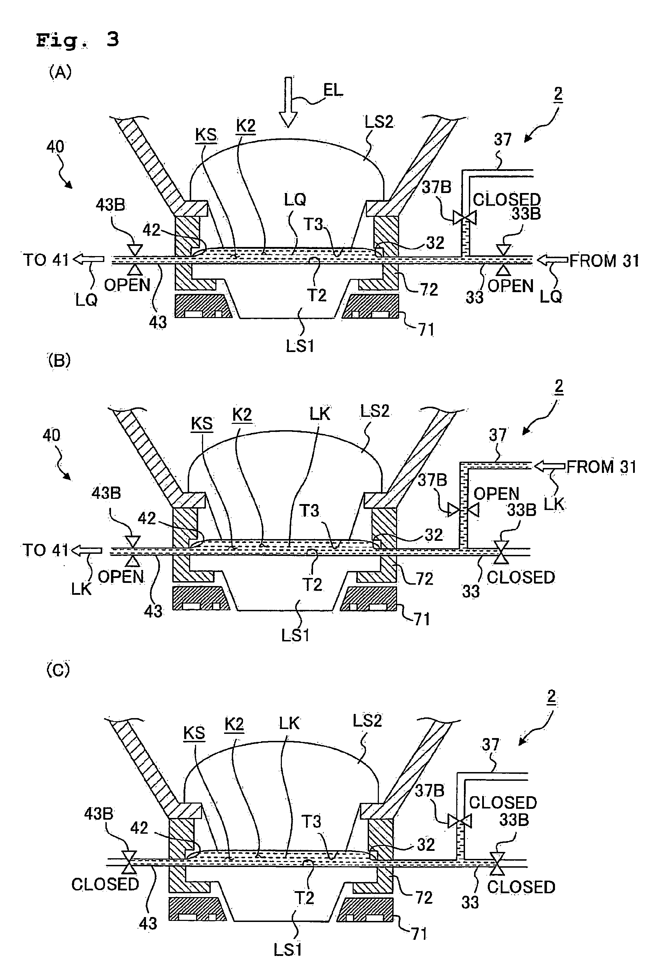

Next, an explanation will be given about a maintenance method for the exposure apparatus EX with reference to Figs. 3(A) to 3(C). Fig. 3(A) is a drawing showing a state that the exposure light beam EL is being irradiated onto the substrate P. As described above, when irradiating the exposure light beam EL, the control unit CONT controls the third and fifth valves 33B and 37B to open the flow passage of the second supply tube 33 connected to the liquid supply unit 31 and closes the flow passage of the third supply tube 37 connected to the functional fluid supply unit 35. At this time, the control unit CONT controls the fourth valve 43B to open the flow passage of the second recovery tube 43 connected to the liquid recovery unit 41. By doing so, when the exposure light beam EL is irradiated onto the substrate P, the control unit CONT can fill, with the liquid (pure or purified water) LQ, the second space K2 (substitution space KS) between the predetermined first and second optical elements LS1 and LS2 among the plurality of optical elements LS1 to LS7 included in the projection optical system PL.

When the operation of the exposure apparatus EX is stopped or interrupted for a predetermined period of time during, for example, the maintenance of the exposure apparatus EX or the like, the irradiation of the exposure light beam EL is stopped. When the irradiation of the exposure light beam EL is stopped, as shown in Fig. 3(B), the control unit CONT controls the third valve 33B to close the flow passage of the second supply tube 33 connected to the liquid supply unit 31, and controls the fifth valve 37B to open the flow passage of the third supply tube 37 connected to the functional fluid supply unit 35. Namely, when the irradiation of the exposure light beam EL is stopped, the functional fluid LK is supplied to the substitution space KS by the functional fluid supply unit 35, and the supply of the liquid LQ by the liquid supply unit 31 is stopped. At this time, the flow passage of the second recovery tube 43 connected to the liquid recovery unit 41 is open, and the recovering operation of the liquid recovery unit 41 (second liquid recovery mechanism 40) is continued. Then, the operation for supplying the functional fluid LK by the functional fluid supply unit 35 into the substitution space KS including the second space K2 and the recovering operation by the liquid recovery unit 41 are performed for a predetermined period of time, whereby the liquid LQ in the substitution space KS including the second space K2 is substituted by the functional fluid LK. Thus, the control unit CONT controls the driving of the third and fifth valves 33B and 37B which serve as switching devices for switching between the supply of the liquid LQ by the liquid supply unit 31 through the second supply port 32 of the second nozzle member 72 and the supply of the functional fluid LK by the functional fluid supply unit 35, to thereby supply the functional fluid LK into the substitution space KS including the second space K2 so as to substitute this substitution space KS by the functional fluid LK.

The operation for supplying the functional fluid LK by the functional fluid supply unit 35 and the operation for recovering the functional fluid LK by the liquid recovery unit 41 are continued for a predetermined period of time, and after the substitution space KS including the second space K2 is substituted by the functional fluid LK, in other words, after the liquid (pure or purified water) LQ almost completely disappears or is removed from the substitution space KS, then as shown in Fig. 3(C), the control unit CONT controls the third and fifth valves 33B and 37B to close the flow passages of the second and third supply tubes 33 and 37 and controls also the fourth valve 43B to close the flow passage of the second recovery tube 43, thereby stopping the recovering operation by the second liquid recovery mechanism 40. Thus, the control unit CONT is capable of maintaining the state that the substitution space KS including the second space KS is filled with the functional fluid LK.

As described above, the functional fluid LK is oxygenated water (solution), and has a function for suppressing the generation of living microbes. When the operation of the exposure apparatus EX is stopped for a predetermined period of time, for performing the maintenance or the like, in a state that the liquid LQ composed of pure or purified water remains (stagnates) in the substitution space KS, then there is a possibility that any living microbes such as bacteria are generated in the substitution space KS. When any living microbes are generated in the substitution space KS, then there is a possibility that the microbes pollute or contaminate the upper surface T2 of the first optical element LS1 and the lower surface T3 of the second optical element LS2 or the inner wall surface of the second nozzle member 72. If the first and second optical elements LS1 and LS2 are polluted or contaminated, there arise problems such as the lowering in the light transmittance and the distribution of light transmittance, which in turn causes the deterioration of the exposure accuracy and measurement accuracy via the projection optical system PL. When the operation of the exposure apparatus EX is resumed to supply the liquid LQ into the substitution space KS, if the upper surface T2 of the first optical element LS1 and the lower surface T3 of the second optical element LS2 or the inner wall surface of the second nozzle member 72 are polluted, the supplied liquid LQ, despite being clean, is also contaminated by the polluted upper surface T2 of the first optical element LS1 and lower surface T3 of the second optical element LS2 or the polluted inner wall surface of the second nozzle member 72, which in turn lowers the light transmittance of the liquid LQ. As described above, when the liquid LQ cannot be maintained to be clean and any living microbes are generated due to the liquid LQ, then the state of the projection optical system PL deteriorates and it becomes difficult to maintain the exposure accuracy and the measurement accuracy. Although there is a possibility that the generation of living microbes is suppressed by continuing the operations for supplying and recovering the liquid LQ by the second liquid immersion mechanism 2, namely, by allowing the liquid LQ to continuously flow into the substitution space KS, it is difficult to continue the operations for supplying and recovering the liquid LQ by the second liquid immersion mechanism 2 when the operation of the exposure apparatus EX is stopped for a predetermined period of time, for example, during the maintenance or the like. In addition, the substitution space KS is a closed space surrounded by the first optical element LS1, the second optical element LS2, and the second nozzle member 72. Therefore, when the upper surface T2 of the first optical element LS1 and the lower surface T3 of the second optical element LS2 or the inner wall surface of the second nozzle member 72 are polluted, a great amount of labor and hour is necessary to, for example, dismantle the projection optical system PL (barrel PK) so as to performing cleaning for the polluted first and second optical elements LS1, LS2 and/or second nozzle member 72.

In view of the above situation, when the irradiation of the exposure light beam EL is stopped, the substitution space KS including the second space K2 is substituted by the functional fluid LK to thereby prevent the generation of living microbes in the substitution space KS, and to prevent the pollution of the respective objects (first and second optical elements LS1 and LS2, the second nozzle member 72, etc.) forming the substitution space KS. Even if any living microbes are generated in the substitution space KS, the living microbes can be removed (killed) by substituting the liquid LQ in the substitution space KS by the functional fluid LK.

As described above, the functional fluid LK is a solution (diluted solution) obtained by mixing (dissolving) a predetermined amount of oxygenated water in pure or purified water. The oxygenated water can sufficiently suppress the generation of living microbes, and is easy to handle. In this embodiment, the concentration of the oxygenated water in the solution is controlled to be not more than 10⁻⁶% (not more than 10 ppb). The concentration of about 10⁻⁶% of the oxygenated water in the solution to suppress the generation of living microbes. By controlling the concentration of the oxygenated water to be not more than 10⁻⁶%, the solution is made to be easily handled, and to made to sufficiently suppress the generation of living microbes while reducing its influence on the operator and to the members which make contact with the functional fluid LK (first and second optical elements LS1 and LS2, second nozzle member 72, supply tubes 33 and 37, and recovery tube 43, etc.). Of course, the concentration of the oxygenated water in the solution may be set to be not less than 10⁻⁶% depending on the properties of the members which come into contact with the functional fluid LK. Alternatively, any oxygenated water which is not diluted may be used as the functional fluid LK.

When the substitution space KS is substituted by the functional fluid LK, the second liquid immersion mechanism 2 may fill almost all of the substitution space KS with the functional fluid LK, or may dispose the functional fluid LK in a part of the substitution space KS so that the functional fluid LK comes into contact with the area which comes in contact with the liquid LQ, the area being on the surfaces of the objects (first and second optical elements LS1 and LS2 and the sound nozzle member 72) forming the substitution space KS. By filling almost all of the substitution space KS with the functional fluid LK, the generation of living microbes can be more reliably suppressed.

As described above, when the irradiation of the exposure light beam EL is stopped, specifically when the operation of the exposure apparatus EX is stopped and the operations for supplying and recovering the liquid LQ into the substitution space KS are stopped, then by substituting the substitution space KS by the functional fluid LK having the function for suppressing the generation of living microbes, it is possible to reduce the influence of the liquid LQ on the projection optical system PL, thereby maintaining the exposure accuracy and the measurement accuracy.

The functional fluid LK is not limited to a solution containing oxygenated water, and may use, as the functional fluid LK, diluted solutions (solutions) containing hydrochloric acid, sulfuric acid, nitric acid, and phosphoric acid, etc., or diluted solutions (solutions) containing an alkali-based substance. Alternatively, it is allowable to use, as the functional fluid LK, organic solvents such as alcohols, ethers, abzol, and HFE or the like, or a mixture of these. The generation of living microbes can also be suppressed by using these functional fluids. It is allowable to add an antibacterial agent, an antiseptic agent, and/or the like to these various functional fluids LK. Alternatively, it is allowable to add the antibacterial agent, the antiseptic agent and/or the like to the liquid LQ (pure or purified water) to be used as the functional fluid LK.

### Second embodiment

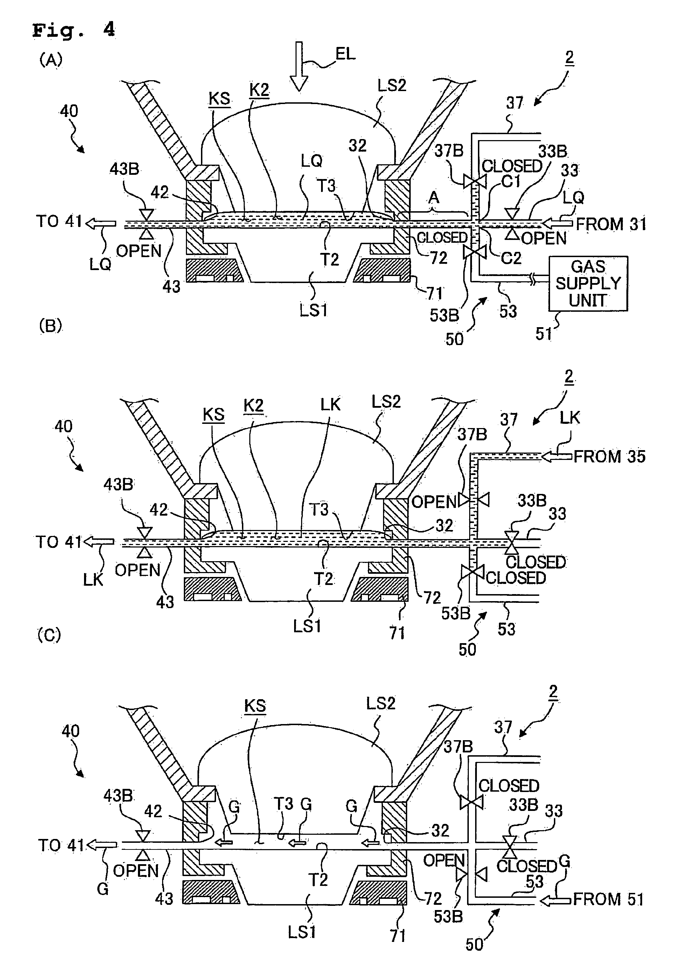

Next, an explanation will be given about a maintenance method of a second embodiment with reference to Figs. 4(A) to 4(C). In the following description, constitutive parts or components same as or equivalent to those in the above-described embodiment are designated with same reference numerals, and description thereof is simplified or omitted. The feature of this embodiment is that, after the substitution space KS is substituted by the functional fluid LK, a gas G is supplied into the substitution space KS to remove the functional fluid LK from the substitution space KS.

In Fig. 4(A), similarly to the above-described embodiment, the second liquid immersion mechanism 2 includes a second supply tube 33 one end of which is connected to the liquid supply unit 31 and the other end of which is connected to the second supply port 32 of the second nozzle member 72; and a third supply tube 37 one end of which is connected to the functional fluid supply unit 35 and the other end of which is connected to the second supply tube 33 at an intermediate portion thereof.

In this embodiment, the functional fluid supply unit 35 supplies, as the functional fluid LK, a liquid which volatilizes more easily than the liquid LQ. It is preferable that the functional fluid LK has solubility in (affinity for) the liquid LQ. In this embodiment, pure or purified water is used as the liquid LQ; and methanol which volatilizes more easily than pure or purified water and has solubility in (affinity for) pure or purified water is used as the functional fluid LK. As the functional fluid LK, it is sufficient that the liquid volatilizes more easily (has higher volatility) than the liquid (pure or purified water) LQ and has solubility in (affinity for) the liquid LQ, and it is possible to use, as the functional liquid LK, alcohol such as ethanol and isopropylalcohol (IPA), ether such as dimethylether and diethylether, or a mixture thereof. The functional fluids have the function for suppressing the generation of living microbes.

In addition, the exposure apparatus EX includes a gas supply system 50 capable of supplying a gas G into the substitution space KS. The gas supply system 50 includes a gas supply unit 51 which supplies a predetermined gas G; and a fourth supply tube 53 one end of which is connected to the gas supply unit 51 and the other end of which is connected to an intermediate portion of the second supply tube 33 of the second liquid immersion mechanism 2. To an intermediate portion of the fourth supply tube 53, a sixth valve 53B which opens and closes the flow passage of the fourth supply tube 53 is provided. The gas supply unit 51 includes a filter unit and/or the like which removes foreign matters from the gas to be supplied to clean the gas. In this embodiment, the gas supply unit 51 supplies dry air. It is allowable that the gas supply unit 51 supplies a gas other than dry air, such as dry nitrogen or the like. The supplying operation of the gas supply unit 51 and the opening and closing operations of the sixth valve 53B are controlled by the control unit CONT.

In this embodiment, a connecting portion (joining portion) C1 of the third supply tube 37 at which the third supply tube 37 and the second supply tube 33 are connected (jointed) to each other is set at approximately same position as that of a connecting portion (joining portion) C2 at which the fourth supply tube 53 and the second supply tube 33 are connected with each other. The gas G fed out from the gas supply unit 51 flows through the fourth supply tube 53, and then flows through an area A, of the second supply tube 33, between the second supply port 32 and the connecting portion C2 at which the supply tube 33 is connected to the fourth supply tube 53, and is supplied into the substitution space KS through the second supply port 32. Namely, the gas G fed out from the gas supply unit 51 flows through the area A as a part of the second supply tube 33 forming the liquid supply channel of the second liquid immersion mechanism 2 and is then supplied into the substitution space KS; and in the area A of the second supply tube 33, the liquid supply channel of the second liquid immersion mechanism 2 and the gas supply channel of the gas supply system 50 are made common.

In the second supply tube 33, in the area A between the second supply port 32 and the connecting portions C1 and C2 at which the second supply tube 33 is connected to the third and fourth supply tubes 37 and 53 respectively, each of the liquid LQ supplied from the liquid supply unit 31, the functional fluid LK supplied from the functional fluid supply unit 35, and the gas G supplied from the gas supply unit 51 flows through the area A. Namely, the liquid supply channel in which the liquid LQ and the functional fluid LK supplied from the liquid supply unit 31 and the functional fluid supply unit 35 of the second liquid immersion mechanism 2 respectively and the gas supply channel in which the gas G supplied from the gas supply unit 51 of the gas supply system 50 flows are made common in the area A of the second supply tube 33.

When irradiating the exposure light beam EL, similarly to the above-described embodiment and as shown in Fig. 4(A), the control unit CONT controls the third, fourth, and fifth valves 33B, 43B, and 37B to open the flow passage of the second supply tube 33 connected to the liquid supply unit 31 and to close the flow passage of the third supply tube 37 connected to the functional fluid supply unit 35, and opens the flow passage of the second recovery tube 43 connected to the liquid recovery unit 41. At this time, the control unit CONT controls the sixth valve 53B to close the flow passage of the fourth supply tube 53 connected to the gas supply unit 51. Afterwards, when irradiating the exposure light beam EL onto the substrate P, the control unit CONT fills the second space K2 (substitution space KS) between the first and second optical elements LS1 and LS2 with the liquid (pure or purified water) LQ. Thereafter, for preventing the vibrations due to the flow of the liquid LQ, it is allowable to irradiate the exposure light beam EL with all the valves are closed.

When the operation of the exposure apparatus EX is stopped for a predetermined period of time during, for example, the maintenance of the exposure apparatus EX or the like, the irradiation of the exposure light beam EL is stopped. When the irradiation of the exposure light beam EL is stopped, as shown in Fig. 4(B), the control unit CONT controls the third and fifth valves 33B and 37B to close the flow passage of the second supply tube 33 connected to the liquid supply unit 31 and to open the flow passage of the third supply tube 37 connected to the functional fluid supply unit 35. At this time, the flow passage of the recovery tube 43 connected to the liquid recovery unit 41 is open. The flow passage of the fourth supply tube 53 connected to the gas supply unit 51 is closed. Then, by performing the operation for supplying the functional fluid LK from the functional fluid supply unit 35 into the substitution space KS including the second space K2 and the operation for recovering the functional fluid LK by the liquid recovery unit 41 for a predetermined period of time, the substitution space KS including the second space K2 is substituted by the functional fluid (methanol) LK.

After the operation for supplying the functional fluid LK by the functional fluid supply unit 35 and the recovering operation by the liquid recovery unit 41 are continued for a predetermined period of time and the substitution space KS including the second space K2 is substituted by the functional fluid LK (the liquid LQ almost disappears in the substitution space KS), the control unit CONT controls the third and fifth valves 33B and 37B to close the flow passages of the second and third supply tubes 33 and 37 and controls the sixth valve 53B to open the flow passage of the fourth supply tube 53, as shown in Fig. 4(C). At this time, the flow passage of the second recovery tube 43 is open and the recovering operation by the liquid recovery unit 41 (second liquid recovery mechanism 40) is continued. Then, for removing the functional fluid LK from the substitution space KS, the control unit CONT drives the gas supply unit 51 of the gas supply system 50 to supply the gas G into the substitution space KS. The control unit CONT performs the gas supplying operation by the gas supply system 50 concurrently with the recovering operation (sucking operation) by the second liquid recovery mechanism 40. The control unit CONT uses the gas supply system 50 to supply the gas G into the substitution space KS, to thereby move, by the flow of the gas, the functional fluid LK in the substitution space KS toward the second recovery port 42, thereby making it possible to promote the removal of the functional fluid LK.

The functional fluid LK has high volatility. Therefore, by supplying the gas G, drying (volatilization) of the functional fluid LK is promoted, thereby making it possible to remove the functional fluid LK in a short period of time. In addition, the functional fluid LK has solubility in (affinity for) the liquid LQ. Therefore, it is possible to remove the liquid LQ remaining in the substitution space KS sufficiently together with the functional fluid LK.

The gas supply system 50 can supply the gas G by blowing the gas G onto the surfaces of objects forming the substitution space KS, namely onto the upper surface T2 of the first optical element LS1 and the lower surface T3 of the second optical element LS2, or onto the inner wall surface of the second nozzle member 72, or the like. By doing so, it is possible to move the functional fluid LK adhering to (remaining on) the surfaces of the objects forming the substitution space KS smoothly toward the second recovery port 42 or to quickly dry the functional fluid LK, thereby making it possible to remove the functional fluid LK in a short period of time. As described above, since the liquid with high volatility is used as the functional fluid LK of this embodiment, by supplying the gas G in a blowing manner onto the upper surface T2 and the lower surface T3 of the first, second optical elements LS1 and LS2 and the like, or onto the inner wall surface of the second nozzle member 72, it is possible to remove the functional fluid LK from the substitution space KS in a short period of time.

When the gas G is to be blown onto the surfaces of the objects forming the substitution space KS, it is allowable to arrange a guide member (flow-rectifying member) which controls the flow of the gas G, for example, in the vicinity of the second supply port 32 and/or the like. The gas G supplied into the substitution space KS through the second supply port 32 is blown onto the surfaces of the objects forming the substitution space KS by the guide member. Alternatively, it is also allowable that a gas blower port capable of supplying the gas into the substitution space KS is provided at a position different from the position of the second supply port 32; and that the gas G is supplied into the substitution space KS through the gas blower port. Still alternatively, it is allowable to blow the gas G through the gas blower port onto the surfaces of the objects forming the substitution space KS.

It is also allowable that the gas supply system 50 does not blow the gas onto the surfaces of the objects forming the substitution space KS. Since the functional fluid LK has high volatility, by supplying the gas into the substitution space KS, the drying (volatilization) of the functional fluid LK is promoted, thereby making it possible to promote the quick removal of the functional fluid LK from the substitution space KS.

As described above, after the substitution space KS including the second space K2 is substituted by the functional fluid LK, the gas G is supplied into the substitution space KS by using the gas supply system 50 to sufficiently dry the surfaces of the objects forming the substitution space KS (to remove the liquid component from the surfaces), thereby making it possible to suppress the generation of living microbes.

In this embodiment, since the liquid supply channel of the second liquid immersion mechanism 2 and the gas supply channel of the gas supply system 50 are made to be common, the liquid LQ and/or the functional fluid LK remaining in the area A of the second supply tube 33 can be removed by the flow of the gas G. It is allowable that the liquid supply channel of the second liquid immersion mechanism 2 and the gas supply channel of the gas supply system 50 are provided independently from each other, instead of making the channels to be common.

### Third embodiment

Next, a third embodiment will be described. In the above-described second embodiment, when the irradiation of the exposure light beam EL is stopped, the substitution space KS is substituted by one kind of functional fluid (methanol) LK, and thereafter, the gas G is supplied for removing the functional fluid LK. The third embodiment, however, has a feature that the substitution space KS is substituted by a plurality of kinds of functional fluids in order (successively) when the irradiation of the exposure light beam EL is stopped.

In the following, an explanation will be given about a case in which the substitution space KS is substituted successively by two kinds of functional fluids LK1 and LK2. In this case, the first functional fluid LK1 has solubility in the liquid LQ, and the second functional fluid LK2 volatilizes more easily than the first functional fluid LK1.

After exposing the substrate P by filling the substitution space KS with the liquid LQ, the control unit CONT substitutes the substitution space KS by the first functional fluid LK1 which has solubility in the liquid LQ. In this embodiment, the liquid LQ is pure or purified water. Therefore, it is possible to use, as the first functional fluid LK1, methanol having solubility in (affinity for) pure or purified water. Afterwards, the control unit CONT substitutes the first functional fluid LK1 in the substitution space KS by the second functional fluid LK2 which volatilizes more easily than the first functional fluid LK1. As the second functional fluid LK2, it is possible to use diethylether (or dimethylether) which volatilizes more easily than methanol. After the pure or purified water in the substitution space KS is substituted by methanol, then by removing this methanol, pure or purified water remaining in the substitution space KS can be sufficiently removed together with methanol. Then, after substituting the second functional fluid LK2 such as methanol in the substitution space KS by diethylether or the like having high volatility, the gas G is supplied into the substitution space KS to thereby quickly remove a liquid component including the second functional fluid LK2 such as diethylether from the substitution space KS.

Since Diethylether or the like has very high volatility, Diethylether or the like can be quickly removed (dried) by supplying the gas G. However, Diethylether or the like has solubility in (affinity for) pure or purified water which is lower than that of methanol. Therefore, in a case that the pure or purified water in the substitution space KS is substituted by diethylether after the substrate P has been exposed while filling the substitution space KS with pure or purified water, there arise a high possibility that, when the gas G is supplied, pure or purified water remains in the substitution space KS even though diethylether is removed. In view of above, after the substrate P has been exposed while filling the substitution space KS with pure or purified water, the pure or purified water in the substitution space KS is substituted by methanol having high affinity for pure or purified water and then methanol is substituted by diethylether, thereby making it possible to prevent pure or purified water from remaining and to quickly remove (dry) the liquid component from the substitution space KS.

In order to substitute the substitution space KS successively by two kinds of functional fluids LK1 and LK2, it is allowable, for example, a first tank which accommodates the functional fluid LK1 and a second tank which accommodates the functional fluid LK2 are provided to the functional fluid supply unit 35 separately from each other and to provide a switch valve which switches joint tubes and joint portions to be joined to the third supply tube 37 from the tanks respectively. It is possible to increase the number of tanks depending on the number of kinds of the functional fluids to be used.

As the second functional fluid LK2, a fluorine-based inert liquid may be used. The fluorine-based inert liquid is exemplified by hydrofluorocarbon ether (HFE) and hydrofluorocarbon (HFC), and in particular, hydrofluorocarbon is preferably used. Hydrofluorocarbon is exemplified by "Vertrel XF" produced by DU PONT-MITSUI FLUOROCHEMICALS COMPANY, LTD. Vertrel XF has high volatility (quick drying property) and a cleaning function. Vertrel XF has a characteristics that its evaporation (latent heat of vaporization) is relatively small although Vertrel XF has high volatility (quick drying property). Therefore, after the substrate P has been exposed by filling the substitution space KS with pure or purified water, the pure or purified water in the substitution space KS is substituted by methanol having high affinity for pure or purified water, and then methanol is substituted with Vertrel XF or the like, to thereby make it possible to prevent pure or purified water from remaining, to quickly remove (dry) the liquid component from the substitution space KS, and to prevent the pollution of the objects (first and second optical elements LS1 and LS2, the second nozzle member 72, etc.) forming the substitution space KS. In addition, it is also possible to make temperature change due to the heat of evaporation to be relatively small in the objects such as the first and second optical elements LS1 and LS2, the second nozzle member 72, etc.

In this embodiment, the explanation is made above a case in which the gas G is supplied after the substitution space KS has been substituted by the second functional fluid LK2 such as diethylether, hydrofluorocarbon (Vertrel XF) or the like. However, the supply of the gas G may be omitted. Since the second functional fluid LK2 has high volatility, the second functional fluid LK2 can be quickly removed (dried) from the substitution space KS even if the supply of the gas G is omitted.

In this embodiment, although the explanation is given about the example in which the substitution space KS is substituted by two kinds of functional fluids LK1 and LK2 in order, the substitution space KS may be substituted successively by three or more kinds of arbitrary functional fluids.

For example, it is also allowable that the substitution space KS which had been filled with pure or purified water is substituted by methanol, and then the substitution space KS is substituted by diethylether, and thereafter, the substitution space KS is substituted by hydrofluorocarbon (Vertrel XF).

In this embodiment, the substitution space KS is firstly substituted by the first functional fluid LK1 which has solubility in the liquid LQ (pure or purified water), and then substituted by diethylether or hydrofluorocarbon (Vertrel XF) with high volatility, and thereafter, the gas G is supplied. However, after the liquid LQ is sufficiently (completely) removed from the substitution space KS, the substitution space KS may be kept in a state in which the substitution space KS is filled with the second functional fluid LK2 such as diethylether, hydrofluorocarbon, or the like. Diethylether and hydrofluorocarbon, etc., have the function for suppressing the generation of bacteria and the like. Accordingly, by keeping the state that the substitution space KS is filled with the second functional fluid LK2, it is possible to prevent the pollution of the objects (first and second optical elements LS1 and LS2, the second nozzle member 72, etc.) forming the substitution space KS. As described above, fluorine-based inert liquids such as hydrofluorocarbon ether (HFE) and hydrofluorocarbon (HFC) are listed as examples of the second functional fluid LK2. However, the fluorine-based inert liquids may be used as the functional fluid LK of the first embodiment and the second embodiment.

### Fourth embodiment

Next, a fourth embodiment will be described. As in the above-described second and third embodiments, when the gas G is supplied into the substitution space KS to remove the functional fluid LK from the substitution space KS, there is a possibility that the temperatures of the objects forming the substitution space KS are changed (lowered) due to the heat of evaporation of the functional fluid LK. In view of this, in this embodiment, the operation for supplying the gas G into the substitution space KS is performed while adjusting the temperatures of the objects forming the substitution space KS.

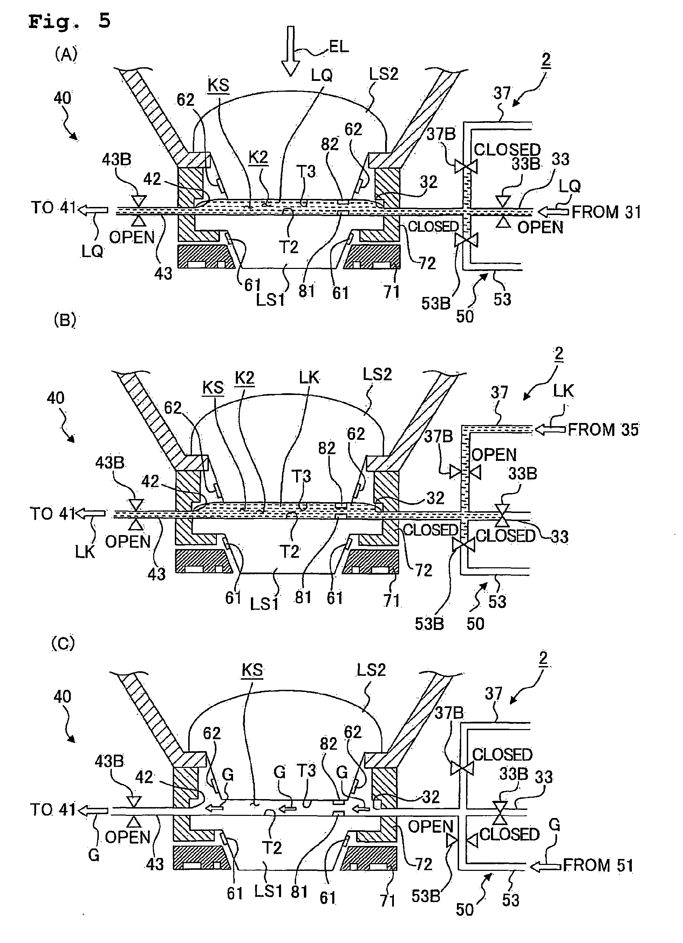

In Fig. 5(A), the exposure apparatus EX includes, similarly to the second and third embodiments, a second supply tube 33 one end of which is connected to the liquid supply unit 31 and the other end of which is connected to the second supply port 32 of the second nozzle member 72; a third supply tube 37 one end of which is connected to the functional fluid supply unit 35 and the other end of which is connected to the second supply tube 33 at an intermediate position thereof; and a fourth supply tube 53 one end of which is connected to the gas supply unit 51 and the other end of which is connected to the second supply tube 33 at an intermediate position thereof. The exposure apparatus EX further includes a first temperature-adjusting unit 61 which adjusts the temperature of the first optical element LS1 as the object forming the substitution space KS, a second temperature-adjusting unit 62 which adjusts the temperature of the second optical element LS2 as the object forming the substitution space KS, a first temperature detector 81 which detects the temperature of the first optical element LS1, and a second temperature detector 82 which detects the temperature of the second optical element LS2. The first temperature-adjusting unit 61 and the first temperature detector 81 are provided to the first optical element LS1 at positions at which the first temperature-adjusting unit 61 and the first temperature detector 81 do not disturb the irradiation of the exposure light beam EL and do not influence the states of the first and second liquid immersion areas LR1 and LR2. Similarly, the second temperature-adjusting unit 62 and the second temperature detector 82 are provided in the second optical element LS2 at positions at which the second temperature-adjusting unit 62 and the second temperature detector 82 do not disturb the irradiation of the exposure light beam EL and do not influence the states of the second liquid immersion area LR2.

The first and second temperature-adjusting units 61 and 62 are connected to the control unit CONT and operations thereof are controlled by the control unit CONT. The first and second temperature detectors 81 and 82 are connected to the control unit CONT and results of detections by the detectors respectively are outputted to the control unit CONT. The control unit CONT controls the first temperature-adjusting unit 61 based on the result of detection performed by the first temperature detector 81 and regulates, within an allowable range, a temperature change of the first optical element LS1 with respect to a target temperature . Similarly, the control unit CONT controls the second temperature-adjusting unit 62 based on the result of detection performed by the second temperature detector 82 and regulates, within an allowable range, a temperature change of the second optical element LS2 with respect to a target temperature.

When irradiating the exposure light beam EL, similarly to the above-described embodiments, the second space K2 (substitution space KS) between the first and second optical elements LS1 and LS2 is filled with the liquid (pure or purified water) LQ as shown in Fig. 5(A).

When the irradiation of the exposure light beam EL is stopped during, for example, the maintenance of the exposure apparatus EX, then the substitution space KS including the second space K2 is substituted by the functional fluid (methanol) LK, as shown in Fig. 5(B).

After the substitution space KS including the second space K2 is substituted by the functional fluid LK, the control unit CONT controls the third and fifth valves 33B and 37B to close the flow passages of the second and third supply tubes 33 and 37 and controls the sixth valve 53B to open the flow passage of the fourth supply tube 53, as shown in Fig. 5(C). At this time, the flow passage of the second recovery tube 43 is open, and the recovering operation by the liquid recovery unit 41 (second liquid recovery mechanism 40) is continued. Then, the control unit CONT drives the gas supply unit 51 of the gas supply system 50 to supply the gas G into the substitution space KS, so as to remove the functional fluid LK from the substitution space KS. By the gas G supplied into the substitution space KS, the removal of the functional fluid LK can be promoted. In addition, since the functional fluid LK has high volatility, the supply of the gas G promotes the drying (volatilization) of the functional fluid LK. At this time, there is a possibility that temperatures of the first and second optical elements LS1 and LS2 forming the substitution space KS are changed (lowered) due to the heat of evaporation of the functional fluid LK. When supplying the gas G to the substitution space KS, the control unit CONT uses the first and second temperature-adjusting units 61 and 62 based on the results of detections by the first and second temperature detectors 81 and 82 to adjust the temperatures of the first and second optical elements LS1 and LS2, and regulates, within an allowable range, temperature-change amounts of the first and second optical elements LS1 and LS2 with respect to target temperatures respectively.

As described above, by supplying the gas G while adjusting the temperatures of the first and second optical elements LS1 and LS2, it is possible to suppress the temperature changes in the first and second optical elements LS1 and LS2 due to the heat of evaporation, and consequently to suppress the thermal deformation of the first and second optical elements LS1 and LS2 due to the temperature changes. Accordingly, this makes it possible to suppress the fluctuation in optical characteristic of the projection optical system PL due to the thermal deformations of the first and second optical elements LS1 and LS2, thereby maintaining the exposure accuracy and the measurement accuracy.

The control unit CONT may control the operation of the gas supply system 50 based on the results of detections by the first and second temperature detectors 81 and 82. For example, when the control unit CONT judges, based on the results of detections by the first and second temperature detectors 81 and 82, that the temperature change in at least one of the first and second optical elements LS1 and LS2 with respect to the target temperature is outside the allowawable range, then the control unit CONT stops the operation for supplying gas G performed by the gas supply system 50. By doing so, the temperature changes in the first and second optical elements LS1 and LS2 due to the heat of evaporation can be reduced. Then, after waiting until the temperature changes in the first and second optical elements LS1 and LS2 with respect to the target temperatures fall within the allowable ranges respectively, the control unit CONT resumes the operation for supplying the gas G by the gas supply system 50 to satisfactorily remove the functional fluid LK. Alternatively, it is also allowable to provide, to the gas supply system 50, a temperature control mechanism capable of adjusting the temperature of the gas G to adjust the temperature of the gas G to be supplied (blown), thereby suppressing the temperature changes in the first and second optical elements LS1 and LS2. For example, when the temperatures of the first and second optical elements LS1 and LS2 lower due to the heat of evaporation, the temperature changes in the first and second optical elements LS1 and LS2 can be prevented by raising the temperature of the gas G to be supplied from the gas supply system 50. In this case, the gas G of which temperature has been adjusted is supplied into the substitution space KS, which in turn adjusts the temperatures of the objects forming the space, namely the temperatures of the first and second optical elements LS1 and LS2.

The control unit CONT can also control both the temperature adjusting operations of the first and second temperature-adjusting units 61 and 62 and the supplying operation of the gas supply system 50, based on the results of detections by the first and second temperature detectors 81 and 82.

In Fig. 5, although the temperature-adjusting units and the temperature detectors are provided in the first and second optical elements LS1 and LS2, it is also allowable to provide a temperature-adjusting unit and a temperature detector to the second nozzle member 72 to suppress temperature change in the second nozzle member 72 caused by the heat of evaporation. That is, the temperature-adjusting unit and temperature detector can be provided on a member, etc. which is easily influenced by the temperature change due to the heat of evaporation, as appropriate. The temperature detector is not necessarily indispensable, and it is allowable that the temperature changes in the objects (optical elements LS1 and LS2, etc.) are obtained in advance through an experiment or simulation, and that the temperature-adjusting unit is operated based on the results of experiment or simulation.

In the second to fourth embodiments described above, the substitution space KS is substituted by methanol, diethylether or the like. Since methanol and diethylether also have a function for removing organic matter adhering to the surfaces of the objects forming the substitution space KS, even if any organic matter enters into the substitution space KS due to any abnormal operation of the liquid supply unit 31 or the like, it is possible to remove the organic matter by substituting the substitution space KS by methanol or the like.

In the second to fourth embodiments described above, the generation of living microbes in the substitution space KS is prevented by sufficiently removing the liquid (pure or purified water) LQ from the substitution space KS. Therefore, to smoothly remove the liquid LQ, it is preferable that the functional fluid LK (LK1, LK2) has solubility in (affinity for) the liquid LQ, and it is allowable that the functional fluid LK does not have the function for removing (killing) living microbes. On the other hand, when the functional fluid LK has the function for removing (killing) living microbes, the living microbes can be removed by filling the substitution space KS with the functional fluid LK even when living microbes are generated in the substitution space KS, which is therefore preferable.

### Fifth embodiment

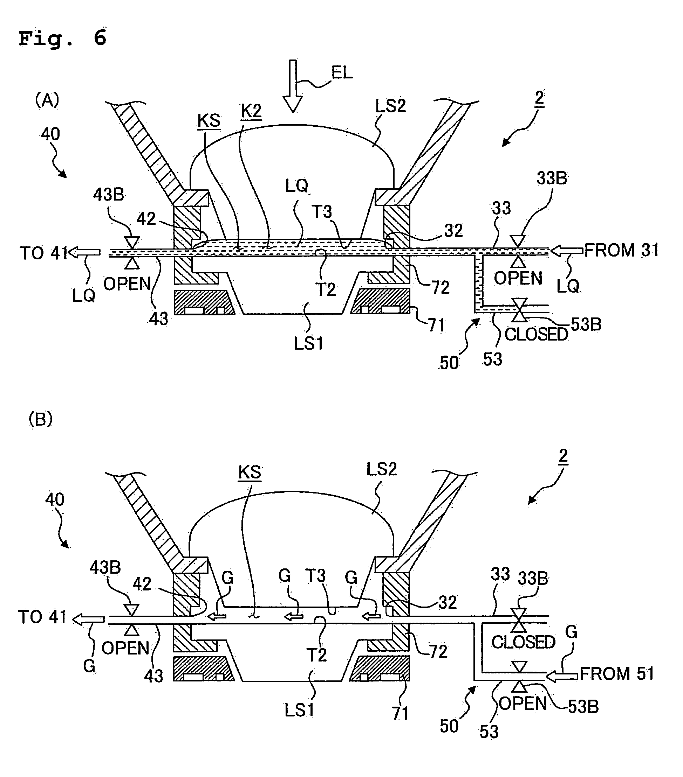

The fifth embodiment will be described with reference to Figs. 6(A) and 6(B). Similarly to the above-described embodiments, when the exposure light beam EL is irradiated, the substitution space KS is filled with the liquid LQ as shown in Fig. 6(A). Then, when the irradiation of the exposure light beam EL is stopped during, for example, the maintenance or the like, as shown in Fig. 6(B), the gas supplying operation into the substitution space KS by the gas supply system 50 is performed, without using the functional fluid LK, concurrently with the recovering operation by the second liquid recovery mechanism 40. Depending on the gas supply condition (velocity, direction, temperature, etc., of the flow of the gas to be supplied) of the gas supply system 50 and the liquid recovery condition (shape, position, and number of the second recovery port 42, the sucking force of the liquid recovery unit 41, etc.) of the second liquid recovery mechanism 40, the liquid LQ in the substitution space KS can be sufficiently removed (dried) by the gas supplying operation of the gas supply system 50 without once substituting the substitution space KS by the functional fluid LK. Therefore, the generation of living microbes due to the remaining liquid LQ can be prevented. Also in this embodiment, it is allowable that the temperature-adjusting units and the temperature detectors are provided on the first and second optical elements LS1 and LS2 or the second nozzle member 72 so as to reduce the temperature changes in the first and second optical elements LS1 and LS2 and the second nozzle member 72 due to the heat of evaporation.

In the above-described second to fifth embodiments, when the exposure apparatus EX is stopped, the substitution space KS is in a state that the substitution space KS is filled with (substituted by) dry air (or dry nitrogen). It is allowable, however, to use arbitrary gas for substituting the substitution space KS provided that the gas has a small influence on the objects forming the substitution space KS.

In the above-described second to fifth embodiments, the substitution space KS between the first optical element LS1 and the second optical element LS2 is substituted by the functional fluid LK. It is allowable that, however, in order to suppress the generation of living microbes in a space (for example, a space between third and fourth optical elements) in the projection optical system PL different from the space between the first optical element LS1 and the second optical element LS2, this space is filled with the functional fluid LK.

In the above-described first to fourth embodiments, the second liquid immersion mechanism 2 uses the second supply port 32 and the second recovery port 42 commonly for the liquid LQ and the functional fluid LK. It is allowable, however, that the supply port and the recovery port for the liquid LQ are provided separately from the supply port and the recovery port for the functional fluid LK.

In the above-described second to fifth embodiments, although the supply port for the liquid LQ and the supply port for the gas G are made common in the second liquid immersion mechanism 2, the supply port for the liquid LQ and the supply port for the gas G may be provided separately.

In the above-described embodiments, at least a part of the liquid LQ recovered by the first liquid recovery mechanism 21 or the second liquid recovery mechanism 41 may be returned to the first liquid supply mechanism 11 or to the second liquid supply mechanism 31. Alternatively, it is allowable that the first liquid LQ recovered by the first recovery mechanism 21 or by the second recovery mechanism 41 is completely discarded and a new, clean liquid LQ is supplied from the first supply mechanism 11 or from the second supply mechanism 31. With respect to the functional fluid LK, when the functional fluid LK is cleaned by ultrafiltration or by a functional filter, then the functional fluid LK can be circulated to be reused. It should be noted that the structure of the liquid immersion mechanism 1 including the nozzle member 70, etc., is not limited to the structure described above; and it is allowable to use for example, the structures described in European Patent Publication No. 1420298, International Publication Nos. 2004/055803, 2004/057589, 2004/057590, and 2005/029559.

### Sixth embodiment

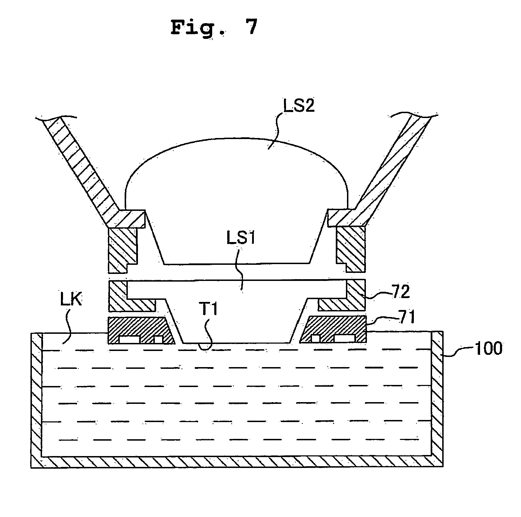

The sixth embodiment will be described with reference to Fig. 7. In the first to fifth embodiments described above, the substitution space KS between the first optical element LS1 and the second optical element LS2 is subjected to the process for suppressing the generation of living microbes in the substitution space KS. It is allowable, however, that the space lower or below than the first optical element LS1, namely the first space K1 (the lower surface T1, the lower surface of the first nozzle member 71, and the space including these surfaces) is subjected to the process for suppressing the generation of living microbes. In this embodiment, as shown in Fig. 7, the first optical element LS1 is immersed (soaked) in the functional fluid LK in the lower surface T1 side thereof. This makes it possible to suppress the generation of living microbes on the lower surface T1 of the first optical element LS1, on the lower surface of the first nozzle member 71 and in the space including these lower surfaces (space on the side of the image plane of the projection optical system PL). In Fig. 7, the functional fluid LK is contained (accommodated) in a container 100, and the first optical element LS1 is immersed together with the first nozzle member 71 in the functional fluid LK contained in the container 100. Here, there is a possibility that any foreign matters generated from the substrate P adhere to the first optical element LS1 and the first nozzle member 71. The foreign matters generated from the substrate P are, for example, organic matter forming the photosensitive material (resist) and the like. Therefore, as the functional fluid LK in which the lower surface T1 side of the first optical element LS1 are immersed, it is preferably to use liquids such as methanol, diethylether or the like capable of removing organic matter. The immersion in the functional fluid LK can be performed during a period of time when the exposure operation by the exposure apparatus EX is not performed, namely, for example, during the maintenance, movement, or transportation of the exposure apparatus. The container 100 is disposed or positioned below the projection optical system PL manually by an operator or with mechanical equipment. The container 100 may be made to be movable on the base member BP.

It is also allowable that after immersing the lower surface T1 side of the first optical element LS1 in the functional fluid LK, a gas is supplied (blown) to the first optical element LS1 while recovering the functional fluid LK to promote the removal of the functional fluid LK. It is also allowable to provide a temperature-adjusting unit capable of adjusting the temperature of the first optical element LS1 and a temperature detector capable of detecting the temperature of the first optical element LS1, so that the gas is supplied while the temperature of the first optical element LS1 is being adjusted. Upon supplying the gas, it is allowable for example, to connect a piping from the gas supply unit 51 or a separation tube (branching tube) separated or branched from the fourth supply tube to the first supply tube joined to the first nozzle member 71. This makes it possible to obtain the effects owing to the gas supply and/or the temperature control also in the space (KS1) on the side of the image plane of the projection optical system PL, similarly to the second to fourth embodiments.

The process using the functional fluid in the space (KS1) on the side of the image plane of the projection optical system PL in the sixth embodiment may be performed concurrently with the process for the substitution space KS described in the first to fifth embodiments, or may be performed before and after the process for the substitution space KS.

The projection optical system PL may be the catadioptric system including dioptric and catoptric elements, or may be a catoptric system including no dioptric element. In this case, a predetermined space between a light transmissive element (for example, dioptric element) and a catoptric element of the projection optical system PL or between the catoptric element and the dioptric element may be filled with a liquid.

In the first to sixth embodiments described above, the explanation is made about a case in which the maintenance of the exposure apparatus EX is described as an example of the time during which the operation of the exposure apparatus EX is stopped for a predetermined period of time. There is a possibility, however, a situation arises in which the operations for supplying and recovering the liquid LQ into and from the substitution space KS by the second liquid immersion mechanism 2 has to be stopped depending on the process condition during the production of a device by using the exposure apparatus EX. Even in such a case, the processes described in the first to sixth embodiments can be executed. Alternatively, the above-described processes can be performed even during nighttime when the operation of the exposure apparatus EX is stopped or during a long-term stop period in which the operation of exposure apparatus EX is stopped such as a long vacation. Still alternatively, the above-described processes can be performed even during the production of the exposure apparatus EX including the projection optical system PL. Further alternatively, the above-described processes can also be performed in a case that the exposure apparatus EX (projection optical system PL) is transported from the exposure apparatus manufacturer to a device manufacturer or the like where the exposure apparatus is to be used to produce the device.

As described above, pure or purified water is used as the liquid LQ in the above-described embodiments. Pure or purified water is advantageous that the pure or purified water can be easily acquired in a large amount in the semiconductor manufacturing factory or the like; and that the pure or purified water exerts no harmful influence on the photoresist on the substrate P, the optical elements (lenses), etc. In addition, the pure or purified water has no harmful influence on the environment, and has a very low content of impurities, so that the pure or purified water is expected to have the function to wash or clean the surface of the substrate P and a surface of the optical element provided on the end portion of the projection optical system PL. When the purity of the pure or purified water supplied from the factory or the like is low, the exposure apparatus may be provided with an ultrapure water-producing unit.

It is approved that the refractive index n of pure or purified water (water) with respect to the exposure light beam EL having a wavelength of about 193 nm is approximately in an extent of 1.44. When the ArF excimer laser beam (wavelength: 193 nm) is used as the light source of the exposure light beam EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In this embodiment, the optical element LS1 is attached to the end portion of the projection optical system PL, and it is possible to adjust, by using this lens, the optical characteristic of the projection optical system PL such as aberrations (spherical aberration, coma aberration, etc.). The optical element to be attached to the end portion of the projection optical system PL may be an optical plate used for adjusting the optical characteristic of the projection optical system PL. Alternatively, the optical element may be a plane-parallel through which the exposure light beam EL is transmissive.

When the pressure between the optical element on the end portion of the projection optical system PL and the substrate P generated due to the flow of the liquid LQ is great, the optical element may be firmly fixed so as not to be moved by the pressure, rather than making the optical element to be exchangeable.

In this embodiments, although the space between the projection optical system PL and the surface of the substrate P is filled with the liquid LQ, it is allowable, for example, that the liquid LQ is filled in a state that a cover glass formed of a plane-parallel is attached to the surface of the substrate P.

Although the liquid LQ in this embodiment is water, the liquid LQ may be a liquid other than water. For example, when the light source of the exposure light beam EL is an F₂ laser, then this F₂ laser beam is not transmitted through water. Therefore, it is allowable to use, as the liquid LQ, a fluorine-based liquid including, for example, perfluoropolyether (PFPE) and fluorine-based oil through which the F₂ laser beam is transmissive. In this case, the portion, which makes contact with the liquid LQ, is subjected to the liquid-attracting treatment, for example, by forming a thin film with a substance having a molecular structure with small polarity including fluorine. Alternatively, other than the above, it is also possible to use, as the liquid LQ, liquids (for example, cedar oil) which have the transmittance with respect to the exposure light beam EL, which have the refractive index as high as possible, and which are stable against the photoresist coated on the surface of the substrate P and the projection optical system PL. Also in this case, the surface treatment is performed depending on the polarity of the liquid LQ to be used.

In the embodiments described above, the light-transmissive type mask (reticle) is used, in which the predetermined light-shielding pattern (or a phase pattern or a light-reducing or dimming pattern) is formed on the light-transmissive substrate. However, in place of such a reticle, as disclosed, for example, in United States Patent No. 6,778,257, it is also allowable to use an electronic mask for forming a transmissive pattern, a reflective pattern, or a light-emitting pattern on the basis of the electronic data of the pattern to be transferred. The present invention is also applicable to the exposure apparatus (lithography system) in which a line-and-space pattern is transferred onto the wafer W by forming interference fringes on the wafer W as disclosed in International Publication No. 2001/035168.

The substrate P described in each of the embodiments is not limited to a semiconductor wafer for producing a semiconductor device, and applicable substrates P of the above-described embodiments include, for example, a glass substrate for the display device, a ceramic wafer for the thin film magnetic head, a master plate (synthetic silica glass, silicon wafer) for the mask or the reticle to be used for the exposure apparatus, and the like.

As for the exposure apparatus EX, the present invention is also applicable to the scanning type exposure apparatus (scanning stepper) based on the step-and-scan system for performing the scanning exposure with the pattern of the mask M by synchronously moving the mask M and the substrate P as well as the projection exposure apparatus (stepper) based on the step-and-repeat system for performing the full field exposure with the pattern of the mask M in a state in which the mask M and the substrate P are allowed to stand still, while successively step-moving the substrate P.

As for the exposure apparatus EX, the present invention is also applicable to the exposure apparatus of such a system that the substrate P is subjected to the full field exposure by using a projection optical system (for example, the dioptric type projection optical system having a reduction magnification of 1/8 and including no catoptric element) with a reduction image of a first pattern in a state in which the first pattern and the substrate P are allowed to substantially stand still. In this case, the present invention is also applicable to the full field exposure apparatus based on the stitch system in which the substrate P is thereafter subjected to the full field exposure with a reduction image of a second pattern while being partially overlaid with the first pattern in a state in which the second pattern and the substrate P are allowed to substantially stand still by using the projection optical system. As for the exposure apparatus based on the stitch system, the present invention is also applicable to the exposure apparatus based on the step-and-stitch system in which at least two patterns are partially overlaid and transferred on the substrate P, and the substrate P is successively moved.

The present invention is also applicable to an exposure apparatus of the twin-stage type. The construction and exposure operation of the twin-stage type exposure apparatus is disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407, contents of which are incorporated herein by reference within a range of permission of the domestic laws and ordinances of the state designated or selected in this international application.

The present invention is also applicable to the exposure apparatus including the substrate stage which holds the substrate P and the measuring stage which is provided with various photoelectric sensors and/or reference member in which reference mark is formed, as disclosed, for example, in Japanese Patent Application Laid-open No. 11-135400.

The embodiments described above adopt the exposure apparatus which fills the liquid locally between the projection optical system PL and the substrate P. However, the present invention is also applicable to a liquid immersion exposure apparatus which performs exposure in a state that the entire surface of the substrate to be exposed is immersed in the liquid, as disclosed, for example, in Japanese Patent Application Laid-open Nos. 6-124873 and 10-303114, United States Patent No. 5,825,043, etc. The structure and exposure operation of such a liquid immersion exposure apparatus are disclosed in detail in United States Patent No. 5,825,043, contents of which are incorporated herein by reference within a range of permission of the domestic laws and ordinances of the state designated or selected in this international application.

As for the type of the exposure apparatus EX, the present invention is not limited to the exposure apparatus for the semiconductor device production which transfers the semiconductor device pattern to the substrate P. The present invention is also widely applicable, for example, to the exposure apparatus for producing the liquid crystal display device or for producing the display as well as the exposure apparatus for producing, for example, the thin film magnetic head, the image pickup device (CCD), the reticle, or the mask.

When the linear motor is used for the substrate stage PST and/or the mask stage MST, it is allowable to use any one of those of the air floating type based on the use of the air bearing and those of the magnetic floating type based on the use of the Lorentz's force or the reactance force. Each of the stages PST, MST may be either of the type in which the movement is effected along the guide or of the guideless type in which no guide is provided. An example of the use of the linear motor for the stage is disclosed in United States Patent Nos. 5,623,853 and 5,528,118, contents of which are incorporated herein by reference respectively within a range of permission of the domestic laws and ordinances of the state designated or selected in this international application.

As for the driving mechanism for each of the stages PST, MST, it is also allowable to use a plane motor in which a magnet unit provided with two-dimensionally arranged magnets and an armature unit provided with two-dimensionally arranged coils are opposed to one another, and each of the stages PST, MST is driven by the electromagnetic force. In this case, any one of the magnet unit and the armature unit is connected to the stage PST, MST, and the other of the magnet unit and the armature unit is provided on the side of the movable surface of the stage PST, MST.

The reaction force, which is generated in accordance with the movement of the substrate stage PST, may be mechanically released to the floor (ground) by using a frame member so that the reaction force is not transmitted to the projection optical system PL, as disclosed, for example, in Japanese Patent Application Laid-open No. 8-166475 (United States Patent No. 5,528,118). The contents of United States Patent No. 5,528,118 are incorporated herein by reference within a range of permission of the domestic laws and ordinances of the state designated or selected in this international application.

The reaction force, which is generated in accordance with the movement of the mask stage MST, may be mechanically released to the floor (ground) by using a frame member so that the reaction force is not transmitted to the projection optical system PL, as disclosed, for example, in Japanese Patent Application Laid-open No. 8-330224 (United States Patent No. 5,874,820). The contents of United States Patent No. 5,874,820 are incorporated herein by reference within a range of permission of the domestic laws and ordinances of the state designated or selected in this international application.

As described above, the exposure apparatus EX according to the embodiments of the present invention is produced by assembling the various subsystems including the respective constitutive elements as defined in claims so that the predetermined mechanical accuracy, the electric accuracy, and the optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which, for example, the temperature and the cleanness are managed.

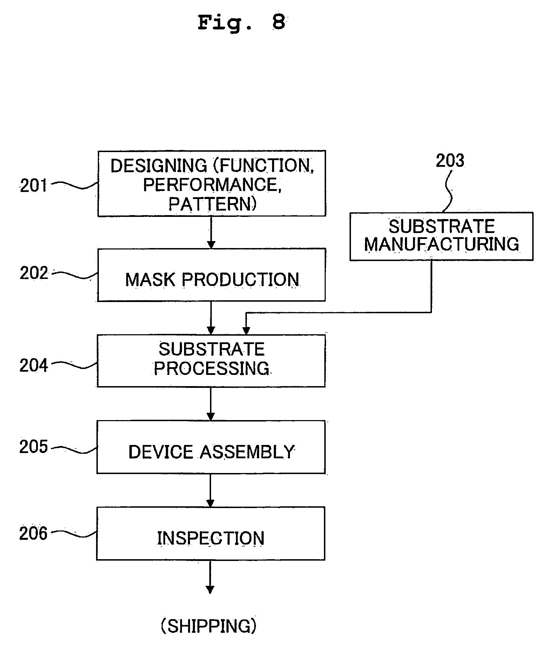

As shown in Fig. 8, the microdevice such as the semiconductor device is produced by performing, for example, a step 201 of designing the function and the performance of the microdevice, a step 202 of producing a mask (reticle) based on the designing step, a step 203 of manufacturing a substrate as a base material for the device, a substrate-processing step (exposure process step) 204 of exposing the substrate with a pattern of the mask by using the exposure apparatus EX of the embodiments described above and of developing the exposed substrate, a step 205 of assembling the device (including a dicing step, a bonding step, and a packaging step), and an inspection step 206. The substrate processing step 204 may include the maintenance operation described in the first to sixth embodiments by incorporating the maintenance operation to the exposure step or by providing the maintenance operation separately from the exposure step.

### INDUSTRIAL APPLICABILITY

Upon exposing a substrate by using the liquid immersion method, it is possible to prevent any harmful influence in the liquid atmosphere, thereby making it possible to produce a device with a desired high accuracy.

## Claims

1. A maintenance method for an exposure apparatus which exposes a substrate by irradiating an exposure light beam onto the substrate via a projection optical system including a plurality of optical elements, the method comprising:
performing exposure for the substrate by irradiating the exposure light beam in a state that a predetermined space between predetermined optical elements among the plurality of optical elements is filled with a first liquid; and
substituting the first liquid in the predetermined space by a second liquid different from the first liquid when the exposure light beam is not irradiated.

2. The maintenance method according to claim 1, wherein the predetermined space is a space between a first optical element closest to an image plane of the projection optical system among the plurality of optical elements in the projection optical system and a second optical element next closest to the image plane with respect to the first optical element.

3. The maintenance method according to claim 1, wherein the first liquid is pure water.

4. The maintenance method according to claim 1, wherein the second liquid has a function for suppressing generation of living microbes.

5. The maintenance method according to claim 1, wherein the second liquid includes oxygenated water.

6. The maintenance method according to claim 5, wherein the second liquid is oxygenated water, and concentration of the oxygenated water is not more than 10⁻⁶%.

7. The maintenance method according to claim 1, wherein after substituting the first liquid in the predetermined space by the second liquid, a gas is supplied into the predetermined space to remove the second liquid from the predetermined space.

8. The maintenance method according to claim 7, wherein the gas is blown onto a surface of an object forming the predetermined space.

9. The maintenance method according to claim 7, wherein the second liquid is a liquid which volatilizes more easily than the first liquid.

10. The maintenance method according to claim 7, wherein the second liquid includes a third liquid which is soluble in the first liquid and a fourth liquid which volatilizes more easily than the third liquid; and
the gas is supplied after substituting the first liquid in the predetermined space by the third liquid and the fourth liquid in this order.

11. The maintenance method according to claim 10, wherein the third liquid is methanol, and the fourth liquid is dimethylether or diethylether.

12. The maintenance method according to claim 10, wherein the third liquid is methanol and the fourth liquid is hydrofluorocarbon.

13. The maintenance method according to any one of claims 7 to 12, wherein the gas is supplied while temperature of the object forming the predetermined space is being adjusted.

14. A maintenance method for an exposure apparatus which exposes a substrate by irradiating an exposure light beam onto the substrate, the method comprising:
performing exposure for the substrate by irradiating the exposure light beam in a state that a predetermined space as a part of an optical path space of the exposure light beam is filled with a liquid; and
supplying a gas into the predetermined space, when the exposure light beam is not irradiated, while adjusting a temperature of an object forming the predetermined space to remove the liquid from the predetermined space.

15. The maintenance method according to claim 14, wherein the gas is blown onto a surface of the object forming the predetermined space.

16. The maintenance method according to claim 14, wherein the exposure apparatus includes a projection optical system which includes a plurality of optical elements; and
the predetermined space is a space between predetermined optical elements among the plurality of optical elements.

17. The maintenance method according to claim 16, wherein the predetermined space is a space between a first optical element, closest to an image plane of the projection optical system among the plurality of optical elements in the projection optical system, and a second optical element next closest to the image plane with respect to the first optical element.

18. The maintenance method according to claim 14, wherein the exposure apparatus further includes a projection optical system; and
the predetermined space is a space on a side of the image plane of the projection optical system.

19. An exposure method for exposing a substrate by irradiating an exposure light beam onto the substrate via a projection optical system including a plurality of optical elements, the method comprising:
irradiating the exposure light beam onto the substrate in a state that a predetermined space between predetermined optical elements among the plurality of optical elements is filled with a first liquid; and
substituting the first liquid in the predetermined space by a second liquid different from the first liquid when the exposure light beam is not irradiated.

20. The exposure method according to claim 19, wherein a predetermined space between the substrate and the projection optical system is filled with the first liquid when the exposure light beam is irradiated onto the substrate.

21. The exposure method according to claim 20, further comprising substituting the second liquid in the predetermined space further by another liquid other than the second liquid after substituting the first liquid in the predetermined space by the second liquid.

22. The exposure method according to claim 21, wherein the second liquid is methanol; and
the another liquid is one liquid selected from a group consisting of diethylether, dimethylether and hydrofluorocarbon.

23. An exposure apparatus which exposes a substrate by irradiating an exposure light beam onto the substrate, comprising:
a projection optical system which includes a plurality of optical elements; and
a liquid immersion mechanism which fills a predetermined space between predetermined optical elements among the plurality of optical elements with a first liquid, and which substitutes the first liquid in the predetermined space by a second liquid different from the first liquid when the exposure light beam is not irradiated.

24. The exposure apparatus according to claim 23, wherein the predetermined space is a space between a first optical element, closest to an image plane of the projection optical system among the plurality of optical elements in the projection optical system, and a second optical element next closest to the image plane with respect to the first optical element.

25. The exposure apparatus according to claim 24, wherein the first liquid is pure water.

26. The exposure apparatus according to claim 24, wherein the second liquid has a function for suppressing generation of living microbes.

27. The exposure apparatus according to claim 23, wherein the liquid immersion mechanism includes:
a supply port which is connected to the predetermined space;
a first liquid supply section which is capable of supplying the first liquid;
a second liquid supply section which is capable of supplying the second liquid; and
a switching device which makes switching between supply of the first liquid by the first liquid supply section through the supply port and supply of the second liquid by the second liquid supply section through the supply port.

28. The exposure apparatus according to claim 23, wherein the liquid immersion mechanism includes a liquid recovery mechanism which recovers the liquid from the predetermined space; and
a gas supply system which supplies a gas into the predetermined space to remove the second liquid from the predetermined space after the first liquid in the predetermined space has been substituted by the second liquid.

29. The exposure apparatus according to claim 28, wherein the gas supply system blows the gas onto a surface of an object forming the predetermined space.

30. The exposure apparatus according to claim 28, comprising a temperature-adjusting device which adjusts temperature of an object forming the predetermined space when the gas is supplied from the gas supply system.

31. The exposure apparatus according to claim 30, comprising a temperature detector which detects the temperature of the object,
wherein the temperature-adjusting device adjusts the temperature of the object based on a result of detection performed by the temperature detector.

32. The exposure apparatus according to claim 29, comprising:
a temperature detector which detects temperature of the object; and
a control device which controls an operation of the gas supply system based on a result of detection performed by the temperature detector.

33. An exposure apparatus which exposes a substrate by irradiating an exposure light beam onto the substrate, comprising:
a liquid immersion mechanism which fills a predetermined space as a part of an optical path space for the exposure light beam when irradiating the exposure light beam onto the substrate;
a gas supply system which supplies a gas into the predetermined space when the exposure light beam is not irradiated to remove the liquid from the predetermined space; and
a temperature-adjusting device which adjusts temperature of an object forming the predetermined space when supplying the gas.

34. The exposure apparatus according to claim 33, wherein a liquid supply channel of the liquid immersion mechanism and a gas supply channel of the gas supply system are made to be common at least partially.

35. The exposure apparatus according to claim 33, wherein the gas supply system blows the gas onto a surface of the object forming the predetermined space.

36. The exposure apparatus according to claim 33, comprising a projection optical system which includes a plurality of optical elements,
wherein the predetermined space is a space between predetermined optical elements among the plurality of optical elements.

37. The exposure apparatus according to claim 36, wherein the predetermined space is a space between a first optical element closest to an image plane of the projection optical system among the plurality of optical elements in the projection optical system and a second optical element next closest to the image plane with respect to the first optical element.

38. The exposure apparatus according to claim 33, further comprising a projection optical system,
wherein the predetermined space is a space on a side of an image plane of the projection optical system.

39. An exposure apparatus which exposes a substrate by irradiating an exposure light beam onto the substrate, comprising:
a projection optical system which includes a plurality of optical elements;
a liquid immersion mechanism which fills a predetermined space between predetermined optical elements among the plurality of optical elements with a liquid; and
a gas supply system which supplies a gas into the predetermined space when the exposure light beam is not irradiated.

40. A method for producing a device, comprising using the exposure apparatus as defined in claim 23 or 33.

41. A method for producing a device, comprising:
an exposure step by using the exposure method as defined in claim 19;
a step for developing the substrate after performing the exposure step; and
a step for processing the developed substrate.
